(19) Europäisches Patentamt / European Patent Office / Office européen des brevets

(11) **EP 2 355 128 A2**

(12) **EUROPEAN PATENT APPLICATION**

(43) Date of publication:
**10.08.2011 Bulletin 2011/32**

(51) Int Cl.:
*H01J 49/06* (2006.01)    *H01J 37/244* (2006.01)
*H01J 37/256* (2006.01)

(21) Application number: **11152420.3**

(22) Date of filing: **27.01.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.01.2010 DE 102010001347**

(71) Applicant: **Carl Zeiss NTS GmbH**
**73447 Oberkochen (DE)**

(72) Inventors:
• **Glasmachers, Albrecht, Prof. Dr.**
**58300, Wetter (DE)**

• **Laue, Alexander**
**45289, Essen (DE)**
• **Aliman, Michel, Dr.**
**73447, Oberkochen (DE)**
• **Mantz, Hubert, Dr.**
**89231, Neu-Ulm (DE)**
• **Zeile, Ulrike, Dr.**
**89522, Heidenheim (DE)**
• **Dömer, Holger, Dr.**
**73441, Bopfingen (DE)**

(74) Representative: **Tongbhoyai, Martin**
**Patentanwälte Freischem**
**Salierring 47-53**
**50677 Köln (DE)**

(54) **Apparatus for transmission of energy and/or for transportation of an ion as well as a particle beam device having an apparatus such as this**

(57) The invention relates to an apparatus (1200,1300) for transmission of energy of an ion to at least one gas particle and/or for transportation of an ion. The invention also relates to a particle beam device having an apparatus such as this. In particular, a container is provided, in which a gas is arranged which has gas particles, wherein the container has a transport axis. Furthermore, at least one first multipole unit and at least one second multipole unit are provided, which are arranged along the transport axis. The first multipole unit and the second multipole unit are formed by printed circuit boards. Furthermore, an electronic circuit is provided, which provides each multipole unit with a potential, such that a potential gradient is generated, in particular along the transport axis.

Fig. 3

## Description

## Description

The invention relates to an apparatus for transmission of energy of an ion to at least one gas particle and/or for transportation of an ion. The invention also relates to a particle beam device having an apparatus such as this.

Particle beam devices have already been in use for a very long time, in order to obtain knowledge about the characteristics and behavior of samples in specific conditions. One of these particle beam devices is an electron beam device, in particular a scanning electron microscope (also referred to in the following text as an SEM).

In the case of an SEM, an electron beam (also referred to in the following text as the primary electron beam) is generated by means of a beam generator, and is focused by means of a beam guidance system, in particular an objective lens, onto a sample to be examined. The primary electron beam is passed over a surface of the sample to be examined, in the form of a raster, by means of a deflection device. The electrons in the primary electron beam in this case interact with the material of the sample to be examined. The interaction results in particular in interaction particles. In particular, electrons are emitted from the surface of the sample to be examined (so-called secondary electrons), and electrons are scattered back from the primary electron beam (so-called back-scattered electrons). The secondary electrons and back-scattered electrons are detected, and are used for image production. This therefore results in an image of the surface of the sample to be examined.

It is also known from the prior art for combination devices to be used to examine samples, in which both electrons and ions can be passed to a sample to be examined. By way of example, it is known for an SEM to additionally be equipped with an ion beam column. An ion beam generator which is arranged in the ion beam column is used to produce ions, which are used for preparation of a sample, (for example removal of a surface of the sample or application of material to the sample), or else for imaging. In this case, the SEM is used in particular to observe the preparation, or else for further examination of the prepared or unprepared sample.

In addition to the already mentioned image production, it is also possible to analyze the energy and/or the mass of interaction particles in more detail. For example, a method is known from mass spectrometry in which secondary ions are examined in more detail. The method is known by the abbreviation SIMS (secondary ion mass spectrometry). In this method, the surface of a sample to be examined is irradiated with a focused primary ion beam. The interaction particles produced in the process, and which are in the form of secondary ions emitted from the surface of the sample, are detected in an analysis unit, and are examined by mass spectrometry. In the process, the secondary ions are selected and identified on the basis of their ion mass and their ion charge, thus allowing conclusions to be drawn about the composition of the sample.

The sample to be examined is irradiated with the focused primary ion beam in known particle beam devices in vacuum conditions ($10^{-3}$ mbar ($10^{-1}$ Pa) to $10^{-7}$ mbar ($10^{-5}$ Pa)), generally using a hard vacuum of $10^{-6}$ mbar ($10^{-4}$ Pa). The secondary ions are also examined in a hard vacuum in the analysis unit. Since the secondary ions have a broad kinetic-energy distribution, it is, however, disadvantageous for the secondary ions to be injected directly into the analysis unit. An intermediate unit is required, which transmits the secondary ions to the analysis unit and which reduces the width of the kinetic-energy distribution before the secondary ions are injected into the analysis unit.

An apparatus for transmission of energy of a secondary ion to gas particles is known from the prior art. This apparatus has a container with an internal area in which a damping gas is located. The container is provided with a longitudinal axis, along which a first electrode, a second electrode, a third electrode and a fourth electrode extend. The first electrode, the second electrode, the third electrode and the fourth electrode are each formed from a metal bar. They form a quadrupole unit, which produces a quadrupole alternating field in the container.

The secondary ions generated by means of an ion beam are introduced into the container and transmit a portion of their kinetic energy to the gas particles by means of impacts. In order to achieve a sufficiently high impact rate for energy reduction, there is a soft vacuum in the region of $5 \times 10^{-3}$ mbar ($5 \times 10^{-1}$ Pa) in the container. The mean free path length of the secondary ions in the soft vacuum is in the millimeter range. The higher the partial pressure of the gas is in the container, the greater is the impact rate, and accordingly also the capability to transmit energy from the secondary ions to the gas particles. After passing through the container, the secondary ions should have only thermal energy.

The kinetic energy of the secondary ions can be subdivided on the one hand into a radial component and on the other hand into an axial component. The radial component causes the secondary ions to diverge from one another radially with respect to the longitudinal axis of the container. This divergence is reduced in the prior art by means of the abovementioned quadrupole unit. The quadrupole unit causes the secondary ions to be stored radially in an alternating field along the longitudinal axis of the container. The quadrupole alternating field is therefore a storage field. In principle, the quadrupole unit acts like a Paul trap, in which restoring forces act on the secondary ions.

It is likewise known for the secondary ions not to be stored statically within the container which is provided with the quadrupole unit, but to oscillate harmonically, and this is referred to in the following text as macro-oscillation. In order to store the secondary ions securely in the quadrupole unit, a suitable storage force ($F_{store}$) should be provided by the quadrupole alternating field, which is proportional to the ratio of the amplitude of the quadrupole alternating field ($U_{Quad}$) to a frequency of the quadrupole alternating field ($f_{Quad}$). Therefore:

$$F_{Store} \sim \frac{U_{Quad}}{f_{Quad}} \qquad [1]$$

It is also known for the macro-oscillation to have a further oscillation in the form of a micro-oscillation superimposed on it, at the frequency of the quadrupole alternating field. The micro-oscillation has an amplitude ($z_{Micro}$) which is proportional to the ratio of the amplitude of the quadrupole alternating field ($U_{Quad}$) to the square of the frequency of the quadrupole alternating field ($f_{Quad}$).

$$Z_{Micro} \sim \frac{U_{Quad}}{(f_{Quad})^2} \qquad [2]$$

In order to avoid secondary ions being lost by the secondary ions striking one of the abovementioned electrodes of the quadrupole unit, an overall oscillation amplitude, which is the sum of the amplitude of the macro-oscillation and the amplitude of the micro-oscillation, should remain less than the radius of the internal area of the container into which the secondary ions have been introduced.

The amplitude of the macro-oscillation can be reduced by transmitting a sufficiently large amount of energy from the secondary ions to the gas particles. In contrast, the amplitude of the micro-oscillation can be reduced by increasing the frequency of the quadrupole alternating field. However, this reduces the restoring forces acting on the secondary ions in the container, as a result of which a greater quadrupole alternating field amplitude is required in order to store the secondary ions securely in the container.

The impacts of the secondary ions with the gas particles reduce the radial component of the kinetic energy, as a result of which the amplitude of the macro-oscillation is reduced, and the secondary ions are focused on the longitudinal axis of the container.

The axial component of the kinetic energy ensures that the secondary ions pass through the container along the longitudinal axis of the container in the direction of the analysis unit. The abovementioned impacts also reduce the axial component of the kinetic energy, however, as a result of which the energy of some secondary ions will no longer be sufficient to pass through the container completely as far as the analysis unit. In the prior art, a potential gradient is therefore provided on the container, wherein a potential associated with that point is provided at each point on the longitudinal axis. The secondary ions are moved axially in the direction of the analysis unit by means of the potential gradient. The potential gradient is configured such that the potential decreases continuously in the direction of the analysis unit, and has a potential well in the area of one end of the container, which is directed at the analysis unit. The secondary ions pass through the container and in the process transmit their energy to the gas particles, until they rest in the potential well.

The known quadrupole unit is subdivided into segments in order to produce the potential gradient. Expressed in other words, the first electrode, the second electrode, the third electrode and the fourth electrode are each subdivided into segments. Each segment has a segment length which is sufficiently short that the field punch-through of the potential is also still sufficiently effective in the center of the individual segments. It has been found that the abovementioned occurs when the segment length corresponds substantially to the core radius of the container. The expression core radius means the radius of the internal area of the container within which the secondary ions can move without striking the abovementioned electrodes.

The abovementioned container has a first end and a second end. An inlet is arranged at the first end, through which the secondary ions enter the internal area of the container from the area in which the secondary ions are generated, and which area is kept in hard-vacuum conditions. A pressure stage is arranged at the inlet. This means an apparatus which separates a first pressure area (in this case a hard vacuum, for example in a sample chamber) from a second pressure area (in this case a soft vacuum in the internal area of the container), such that the vacuum in the first pressure area does not substantially deteriorate. An outlet is provided at the second end of the container, through which the secondary ions leave the container in the direction of the analysis unit. A further pressure stage is arranged at the outlet, which separates the second pressure area (in this case the soft vacuum in the internal area of the container) from a third pressure area (in this case the hard vacuum in the analysis unit), such that the vacuum in the third pressure area does not deteriorate substantially.

With regard to the abovementioned prior art, reference is made, for example, to DE 10 2006 059 162 A1. US 7,473,892 B2, EP 1 185 857 B1, US 5,008,537, US 5,376,791 and WO 01/04611. Furthermore, reference is made to US 2009/0294641 and US 5,576,540.

Analyses have shown that, because of design and vacuum constraints, the core radius should be in the range up to 15 mm. For example, if a core radius of 5 mm is assumed which, for example, has been found to be suitable, the segment length should therefore be 5 mm. If, for example, the container has an extent along its longitudinal axis of 300 mm (which is used in the prior art for adequate transmission of the energy of the secondary ions to the gas particles), 60 segments are therefore required for each of the abovementioned electrodes. The amount of complexity which is required for these 60 segments to make electrical contact with each of the abovementioned electrodes, to isolate them from one another and to arrange them sufficiently well from the mechanical point of view is very high. Furthermore, the complexity for the wiring and drive for the 60 segments is very high.

Furthermore, it is desirable for the distribution of the secondary ions in the radial direction with respect to the longitudinal axis to be very low along the entire longitudinal axis, for example less than 5 mm, in order to allow a sufficiently large number of secondary ions to be passed reliably into the analysis unit.

Therefore, the invention is based on the object of specifying an apparatus for transmission of energy of an ion to at least one gas particle and/or for transportation of an ion, which is of simple design and whose elements can be connected easily. The invention is also based on the object of specifying a particle beam device having an apparatus such as this.

According to the invention, this object is achieved by means of an apparatus having the features of Claim 1. A further apparatus according to the invention is defined by the features of Claim 10. A particle beam device according to the invention is defined by the features of Claim 16. Further features of the invention will become evident from the following description, the following claims and/or the attached figures.

The apparatus according to the invention as claimed in Claim 1 is an apparatus for transmission of energy of at least one ion to at least one gas particle in a gas. Furthermore, the apparatus according to the invention is provided for transportation of an ion. The apparatus according to the invention is provided with a container, in which a gas is arranged which has gas particles. Furthermore, the container has a predeterminable shape and a transport axis, for example a longitudinal axis. Furthermore, the apparatus according to the invention is provided with at least one first multipole unit, for example with a first quadrupole unit, and at least one second multipole unit, for example a second quadrupole unit, which are arranged along the transport axis of the container. The first multipole unit is formed by a first printed circuit board which is matched to the predeterminable shape of the container and has first printed circuit board electrodes for generating a first multipole alternating field, for example a first quadrupole alternating field. The printed circuit board electrodes are accordingly driven such that a first multipole alternating field is generated. Furthermore, the second multipole unit is formed by a second printed circuit board, which is matched to the predeterminable shape of the container and has second printed circuit board electrodes for generarting a second multipole alternating field, for example a second quadrupole alternating field. By way of example, the first multipole alternating field and the second multipole alternating field are identical. Furthermore, at least one electronic circuit is provided for the apparatus according to the invention and provides a potential gradient along the transport axis of the container, wherein a potential which is associated with that point is provided at each point on the transport axis. The potential is constant along a longitudinal extent of the first printed circuit board electrodes and of the second printed circuit board electrodes.

The operation and effect of the apparatus according to the invention will be explained in the following text. First of all, ions are generated, for example secondary ions emitted from a sample. This can be done, for example, by means of focusing an ion beam onto a sample in hard-vacuum conditions, for example in the region of $10^{-6}$ mbar ($10^{-4}$ Pa). The ions are then introduced into the container, and transmit a portion of their kinetic energy to the gas particles, by means of impacts. The secondary ions can also be split into fragments, as a result of which energy is likewise extracted from the secondary ions. In order to achieve a sufficiently high impact rate for energy reduction, there is, for example, a soft vacuum in the region of $5 \times 10^{-3}$ mbar ($5 \times 10^{-1}$ Pa) in the container. The higher the partial pressure of the gas is in the container, the greater is the impact rate, and accordingly also the capability to transmit energy from the ions to the gas particles. After passing through the container, the ions generally only still have thermal energy.

The kinetic energy of the ions can be subdivided on the one hand into a radial component and on the other hand into an axial component. The radial component causes the ions to diverge from one another radially with respect to the longitudinal axis of the container. This divergence is reduced by means of the first multipole unit, for example the first quadrupole unit, and the second multipole unit, for example the second quadrupole unit. The first multipole unit and the second multipole unit result in the ions being stored in a radial area around the longitudinal axis of the container. In principle, the first multipole unit and the second multipole unit act like a Paul trap.

The impacts of the ions with the gas particles reduce the radial component of the kinetic energy, thus reducing the amplitude, as already mentioned above, of the macro-oscillation, and the ions are focusd on the transport axis of the container. The axial component of the kinetic energy ensures that the ions pass through the container along the transport axis of the container in the direction of an analysis unit. However, the abovementioned impacts also decrease the axial component of the kinetic energy, as a result of which the energy of some ions is no longer sufficient to pass completely through the container as far as an analysis unit. A potential gradient is therefore provided on the container. The ions are moved axially in the direction of the analysis unit by means of the potential gradient. The potential gradient is designed such that the potential decreases continuously in the direction of an analysis unit, and has a potential well in the area of one end of the container, which is directed at an analysis unit. The ions pass through the container and in the process transmit their energy to the gas particles, until they rest in the potential well.

The first multipole alternating field, for example the first quadrupole alternating field, and the second multipole alternating field, for example the second quadrupole alternating field, are formed electrically by means of the first printed circuit board and the second printed circuit board. As already mentioned above, the invention provides, for example, for the first multipole alternating field and the second multipole alternating field to be identical. It is advantageous for the apparatus according to the invention to be of simple design, and for it to be possible to connect its elements easily. Contact is made with individual elements on the first printed circuit board and on the second printed circuit board via conductor tracks which are arranged in the first printed circuit board and in the second printed circuit board. For example, four first printed circuit board electrodes can be used on the first printed circuit board, and/or four second printed circuit board electrodes on the second printed circuit board. Other embodiments provide for the use of more than four first printed circuit board electrodes and/or four second printed circuit board electrodes, for example 8 or 16 first printed circuit board electrodes and/or 8 or 16 second printed circuit board electrodes.

The apparatus according to the invention costs less than the prior art, because of its simple circuitry and its production.

One embodiment of the apparatus according to the invention additionally or alternatively provides for the first printed circuit board and/or the second printed circuit board to be formed from a bendable and flexible material. For example, at least one printed circuit board of the first and second printed circuit boards is manufactured from epoxy resin, from ceramic or a plastic. However, the invention is not restricted to bendable and flexible materials. In fact, any suitable material can be used.

One embodiment of the apparatus according to the invention additionally or alternatively provides for the first printed circuit board and the second printed circuit board to be formed from an individual (that is to say single) printed circuit board. Furthermore, the single printed circuit board is segmented and has at least one first segment and at least one second segment. The first segment forms the first multipole unit, for example the first quadrupole unit. Furthermore, the second segment forms the second multipole unit, for example the second quadrupole unit. The invention can therefore also be provided with a segment structure. It has also been found that, because of the first printed circuit board and the second printed circuit board, it is always possible to choose a core radius of an internal area of the container to be quite large. These advantages will be explained in more detail further below.

According to the invention, the container has a free internal area which is considerably larger than a free internal area of a container which is used in systems from the prior art, which systems have quadrupole units in the form of bar electrodes. The larger free internal area ensures that even ions with large macro-oscillations and large micro-oscillations can be stored without them striking the multipole units. In the case of the invention, each multipole unit may consist of a plurality of printed circuit board electrodes which are at a distance from the transport axis. With the container having the same maximum external dimensions as the prior art, the invention therefore makes it possible to provide a large internal area in the container, with a radius (core radius) which is available for free propagation of the ions.

A further embodiment of the apparatus according to the invention provides in addition or as an alternative to this for the container to have an internal area which is bounded by at least one internal area wall. Furthermore, the first multipole unit, for example the first quadrupole unit, and the second multipole unit, for example the second quadrupole unit, are arranged on the internal area wall.

Yet another embodiment of the apparatus according to the invention additionally or alternatively provides for the internal area to be circular and to have a radius (core radius). Provision is also made for the first multipole unit and/or the second multipole unit to have a longitudinal extent in the direction of the transport axis which, for example, corresponds to the radius, or essentially to the radius. The first multipole unit and the second multipole unit are each in the form of a segment. As mentioned above, the length of individual segments should be oriented on the core radius. Since the core radius can be chosen to be greater than a core radius of an apparatus from the prior art, this reduces the number of segments required and which should be arranged along a predeterminable distance on the transport axis. This is a further advantage of the invention.

Here, it is explicitly noted that the invention is not restricted to a container having a circular internal area. In fact, the geometry of the internal area may assume any shape which is suitable for the invention. For example, the internal area may also be essentially rectangular.

One embodiment of the apparatus according to the invention additionally or alternatively provides for the container to have a first end and a second end. The first end has an inlet for ions and a first pressure stage. Furthermore, the second end has an outlet for ions and a second pressure stage. In this case, a pressure stage means an apparatus for separating a first pressure area from a second pressure area. These are advantageous for the apparatus according to the invention, since the pressure in the container of the apparatus is far higher than in an area in which the ions are generated or analyzed.

A further embodiment of the apparatus according to the invention additionally or alternatively provides for the apparatus to have at least one of the following features:

- the container has a longitudinal extent in the direction of the transport axis in the range from 100 mm to 500 mm,

- the container has a longitudinal extent in the direction of the transport axis in the range from 200 mm to 400 mm, or

- the container has a longitudinal extent in the direction of the transport axis of 350 mm.

Yet another embodiment of the apparatus according to the invention additionally or alternatively provides for the apparatus to have at least one of the following features:

- the core radius is in the range from 2 mm to 50 mm,
- the core radius is in the range from 8 mm to 20 mm,
- the core radius is in the range from 9 mm to 12 mm, or
- the core radius is 10 mm, 9 mm or 8 mm.

The invention also relates to a further apparatus having the features of Claim 10. The apparatus is used for transportation of an ion, and is therefore also referred to in the following text as a transport apparatus.

The transport apparatus has a transport axis, for example a longitudinal axis. Furthermore, at least one first multipole device, for example a first quadrupole device, and at least one second multipole device, for example a second quadrupole device, are provided and are arranged along the transport axis. The first multipole device, for example the first quadrupole device, is formed by a first printed circuit board having first printed circuit board electrodes for generating a first multipole alternating field, for example a first quadrupole alternating field. Furthermore, the second multipole device, for example the second quadrupole device, is formed by a second printed circuit board having second printed circuit board electrodes for generating a second multipole alternating field, for example a second quadrupole alternating field. The first multipole alternating field and the second multipole alternating field may be identical.

The first printed circuit board of the transport apparatus according to the invention has a first through-opening. Furthermore, the second printed circuit board of the transport apparatus according to the invention has a second through-opening. The transport axis runs through the first through-opening and through the second through-opening. In particular, at least one the first printed circuit board or the second printed circuit board, or both, has or have a surface which is aligned at right angles to the transport axis of the transport apparatus. Furthermore, for example, the first printed circuit board and the second printed circuit board are arranged with respect to one another in the form of a stack.

Furthermore, the transport apparatus according to the invention has at least one electronic circuit for generating a first potential on the first multipole device, for example the first quadrupole device, and for generating a second potential on the second multipole device, for example the second quadrupole device, in which case the first potential and the second potential can be predetermined.

The above transport apparatus according to the invention is particularly suitable for transporting to an analysis unit the ions which have been braked to a thermal energy after energy has been transmitted from an ion to gas particles. In particular, the transport apparatus according to the invention ensures that ions which are arranged in a potential well are transported to an analysis unit. This is done by moving the potential well axially along the transport axis of the container. The movement is produced by the first potential and the second potential, which can be predetermined appropriately. No kinetic energy is supplied to the ions with this form of transport. They remain focused both axially and radially with respect to the transport axis. This makes it easier to inject the ions into an analysis unit.

A further embodiment of the transport apparatus additionally or alternatively provides for the first multipole device to have at least one first hyperbolic electrode, at least one second hyperbolic electrode, at least one third hyperbolic electrode and at least one fourth hyperbolic electrode. Alternatively or additionally to this, the second multipole device has at least one fifth hyperbolic electrode, at least one sixth hyperbolic electrode, at least one seventh hyperbolic electrode and at least one eighth hyperbolic electrode. Additionally or as an alternative to this, the first multipole device has at least one ninth hyperbolic electrode, at least one tenth hyperbolic electrode, at least one eleventh hyperbolic electrode and at least one twelfth hyperbolic electrode. Furthermore, additionally or as an alternative to this, the second multipole device has at least one thirteenth hyperbolic electrode, at least one fourteenth hyperbolic electrode, at least one fifteenth hyperbolic electrode and at least one sixteenth hyperbolic electrode. However, the transport apparatus is not restricted to the abovementioned embodiments. In fact, the first multipole device and the second multipole device may be designed in any way which is suitable for the transport apparatus according to the invention.

Additionally or alternatively, in yet another embodiment of the abovementioned transport apparatus, the first multipole device is in the form of a disk. In this case, a design in the form of a disk means that the first printed circuit board electrodes are formed by a planar structure which is aligned at right angles to the transport axis. The first multipole device has a predeterminable extent along the transport axis. Additionally or as an alternative to this, the second multipole device is in the form of a disk. Reference is made to the above section with regard to the design in the form of a disk.

Yet another embodiment of the transport apparatus additionally or alternatively provides for the transport apparatus to have at least one third multipole device, for example a third quadrupole device, and at least one fourth multipole device, for example a fourth quadrupole device. By way of example, the third multipole device is in the form of a third printed circuit board having third printed circuit board electrodes for generating a third multipole alternating field. Furthermore, the fourth multipole device is in the form of a fourth printed circuit board having fourth printed circuit board electrodes for generating a fourth multipole alternating field. Furthermore, the first multipole device is connected in parallel with the third multipole device. In addition, the second multipole device is connected in parallel with the fourth multipole device. The parallel connection results in a wave formed from potential wells in the container, in which the ions are arranged. The potential wells are moved periodically axially by appropriately driving the abovementioned printed circuit board electrodes.

The invention also relates to a particle beam device having the features of Claim 16. The particle beam device according to the invention has a sample chamber, in which a sample is arranged. Furthermore, the particle beam device has at least one first particle beam column, wherein the first particle beam column has a first beam generator for generating a first particle beam, and has a first objective lens for focusing the first particle beam onto the sample. Furthermore, at least one means for generating secondary ions which are emitted from the sample, and at least one collecting apparatus for collection of the secondary ions are provided on the particle beam device. The collecting apparatus is used to pass the secondary ions in the direction of at least one analysis unit for analysis of the secondary ions. Furthermore, the particle beam device according to the invention has at least one of the abovementioned apparatuses having at least one of the abovementioned features or having a combination of at least two of the abovementioned features.

By way of example, in the particle beam device according to the invention, the first particle beam column forms the means for generating secondary ions, and is in the form of an ion beam column. However, the invention is not restricted to this, as will be explained in more detail further below.

In one embodiment of the particle beam device according to the invention, the analysis unit is additionally or alternatively in the form of a mass spectrometer, for example a time-of-flight mass spectrometer or ion-trap mass spectrometer. In particular, the analysis unit can additionally or alternatively be arranged detachably on one of the abovementioned embodiments of one of the abovementioned apparatuses, by means of a connecting device. The analysis unit can therefore be designed to be replaceable.

In a further embodiment of the particle beam device according to the invention, the particle beam device additionally or alternatively has a laser unit. By way of example, the means for generating secondary ions comprise the laser unit. The laser unit can be provided in addition to or as an alternative to the first particle beam column, for generating secondary ions.

Yet another embodiment of the particle beam device according to the invention additionally or alternatively provides for the means for generating secondary ions to be arranged on one of the abovementioned apparatuses. For example, the laser unit is arranged on one of the abovementioned apparatuses such that a laser beam passes through at least one of the abovementioned apparatuses as far as the sample. Additionally or as an alternative to this, the means for generating secondary ions, for example the laser unit, can be arranged on the analysis unit.

In yet another embodiment of the particle beam device according to the invention, a second particle beam column is additionally or alternatively provided, wherein the second particle beam column has a second beam generator for generating a second particle beam, and has a second objective lens for focusing the second particle beam onto the sample. In particular, the second particle beam column is in the form of an electron beam column, and the first particle beam column is in the form of an ion beam column. As an alternative to this, the second particle beam column may be in the form of an ion beam column, and the first particle beam column may be in the form of an electron beam column. In a further alternative embodiment, both the first particle beam column and the second particle beam column are each in the form of an ion beam column.

The invention will be explained in more detail in the following text with reference to exemplary embodiments and by means of figures, in which:

Figure 1 shows a schematic illustration of a particle beam device;

Figure 2 shows a further schematic illustration of the particle beam device as shown in Figure 1;

**Figure 3** shows a schematic side view of a particle analysis apparatus;

**Figure 4** shows a schematic illustration in the area of a sample as shown in Figure 2;

**Figure 5A** shows a schematic illustration of an apparatus for energy transmission;

**Figure 5B** shows a further schematic illustration of the apparatus for energy transmission as shown in Figure 5A;

**Figure 5C** shows a schematic illustration of a quadrupole alternating field which is generated by means of the apparatus for energy transmission as shown in Figure 5B;

**Figure 6** shows a schematic illustration of a profile of a guiding potential;

**Figure 7** shows a schematic illustration of one end of the apparatus for energy transmission as shown in Figure 5B, of an ion transmission unit and of an analysis unit;

**Figure 8** shows a plan view of a quadrupole disk as shown in Figure 7;

**Figure 9** shows a section illustration through the quadrupole disk along the line A-A in Figure 8;

**Figure 10** shows a schematic illustration of the ion transmission unit;

**Figure 11** shows a schematic illustration of a first exemplary embodiment of a potential profile in the ion transmission unit;

**Figure 12** shows a schematic illustration of a second exemplary embodiment of a potential profile in the ion transmission unit;

**Figure 13** shows a further schematic illustration of the ion transmission unit;

**Figure 14** shows a schematic illustration of a third exemplary embodiment of a potential profile in the ion transmission unit;

**Figure 15** shows a schematic illustration of a storage cell;

**Figure 16** shows a further schematic side view of a further particle analysis apparatus;

**Figure 17A** shows a schematic illustration of an arrangement of the particle analysis apparatus as shown in **Figure 16** in the particle beam device;

**Figure 17B** shows a further schematic illustration of an arrangement of the particle analysis apparatus as shown in **Figure 16** in the particle beam device; and

**Figure 17C** shows yet another schematic illustration of an arrangement of the particle analysis apparatus as shown in **Figure 16** in the particle beam device.

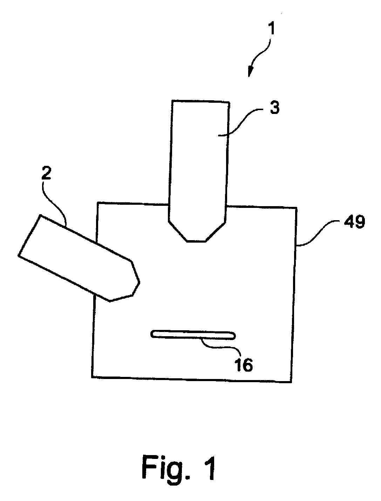

**Figure 1** shows a schematic illustration of one embodiment of a particle beam device 1 according to the invention. The particle beam device 1 has a first particle beam column 2 in the form of an ion beam column, and a second particle beam column 3 in the form of an electron beam column. The first particle beam column 2 and the second particle beam column 3 are arranged on a sample chamber 49, in which a sample 16 to be examined is arranged. It is explicitly noted that the invention is not restricted to the first particle beam column 2 being in the form of an ion beam column and the second particle beam column 3 being in the form of an electron beam column. In fact, the invention also provides for the first particle beam column 2 to be in the form of an electron beam column and for the second particle beam column 3 to be in the form of an ion beam column. A further embodiment of the invention provides for both the first particle beam column 2 and the second particle beam column 3 each to be in the form of an ion beam column.

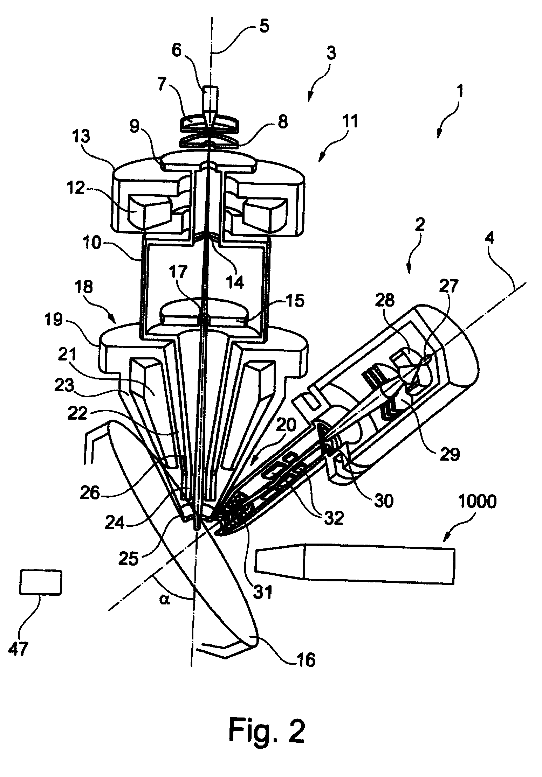

**Figure 2** shows a detailed illustration of the particle beam device 1 shown in **Figure 1**. For clarity reasons, the sample chamber 49 is not illustrated. The first particle beam column 2 in the form of the ion beam column has a first optical axis 4. Furthermore, the second particle beam column 3 in the form of the electron beam column has a second optical axis 5.

The second particle beam column 3, in the form of the electron beam column, will now be described first of all in the following text. The second particle beam column 3 has a second beam generator 6, a first electrode 7, a second electrode 8 and a third electrode 9. By way of example, the second beam generator 6 is a thermal field emitter. The first electrode 7 has the function of a suppressor electrode, while the second electrode 8 has the function of an extractor electrode. The third electrode 9 is an anode, and at the same time forms one end of a beam guide tube 10. A second particle beam in the form of an electron beam is generated by means of the second beam generator 6. Electrons which emerge from the second beam generator 6 are accelerated to the anode potential, for example in the range from 1 kV to 30 kV, as a result of a potential difference between the second beam generator 6 and the third electrode 9. The second particle beam in the form of the electron beam passes through the beam guide tube 10, and is focused onto the sample 16 to be examined. This will be described in more detail further below.

The beam guide tube 10 passes through a collimator arrangement 11 which has a first annular coil 12 and a yoke 13. Seen in the direction of the sample 16, from the second beam generator 6, the collimator arrangement 11 is followed by a pinhole diaphragm 14 and a detector 15 with a central opening 17 arranged along the second optical axis 5 in the beam guide tube 10. The beam guide tube 10 then runs through a hole in a second objective lens 18. The second objective lens 18 is used for focusing the second particle beam onto the sample 16. For this purpose, the second objective lens 18 has a magnetic lens 19 and an electrostatic lens 20. The magnetic lens 19 is provided with a second annular coil 21, an inner pole shoe 22 and an outer pole shoe 23. The electrostatic lens 20 has an end 24 of the beam guide tube 10 and a terminating electrode 25. The end 24 of the beam guide tube 10 and the terminating electrode 25 form an electrostatic deceleration device. The end 24 of the beam guide tube 10, together with the beam guide tube 10, is at the anode potential, while the terminating electrode 25 and the sample 16 are at a potential which is lower than the anode potential. This allows the electrons in the second particle beam to be braked to a desired energy which is required for examination of the sample 16. The second particle beam column 3 furthermore has raster means 26, by means of which the second particle beam can be deflected and can be scanned in the form of a raster over the sample 16.

For imaging purposes, the detector 15 which is arranged in the beam guide tube 10 detects secondary electrons and/or back-scattered electrons, which result from the interaction between the second particle beam and the sample 16. The signals produced by the detector 15 are transmitted to an electronics unit (not illustrated) for imaging.

The sample 16 is arranged on a sample stage (not illustrated), by means of which the sample 16 is arranged such that it can move on three axes which arranged to be mutually perpendicular (specifically an x axis, a y axis and a z axis). Furthermore, the sample stage can be rotated about two rotation axes which are arranged to be mutually perpendicular. It is therefore possible to move the sample 16 to a desired position.

As already mentioned above, the reference symbol 2 denotes the first particle beam column, in the form of the ion beam column. The first particle beam column 2 has a first beam generator 27 in the form of an ion source. The first beam generator 27 is used for generating a first particle beam in the form of an ion beam. Furthermore, the first particle beam column 2 is provided with an extraction electrode 28 and a collimator 29. The collimator 29 is followed by a variable aperture 30 in the direction of the sample 16 along the first optical axis 4. The first particle beam is focused onto the sample 16 by means of a first objective lens 31 in the form of focusing lenses. Raster electrodes 32 are provided, in order to scan the first particle beam over the sample 16 in the form of a raster.

When the first particle beam strikes the sample 16, the first particle beam interacts with the material of the sample 16. In the process, first interaction particles are generated, in particular secondary ions, which are emitted from the sample 16. These are now detected and evaluated by a particle analysis apparatus 1000.

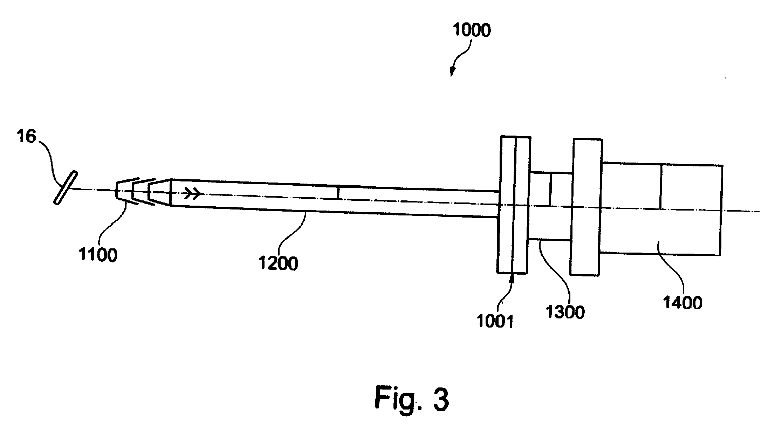

Figure 3 shows a schematic side view of the particle analysis apparatus 1000. The particle analysis apparatus 1000 has a collecting apparatus in the form of an extraction unit 1100, an apparatus for energy transmission 1200, specifically for transmission of energy from the first interaction particles (for example the secondary ions) to neutral gas particles, an ion transmission unit 1300 and an analysis unit 1400. The ion transmission unit 1300 and the analysis unit 1400 are arranged detachably on the sample chamber 49 via a connecting element 1001. This makes it possible to use different analysis units.

The individual units of the particle analysis apparatus 1000 will now be described in more detail in the following text.

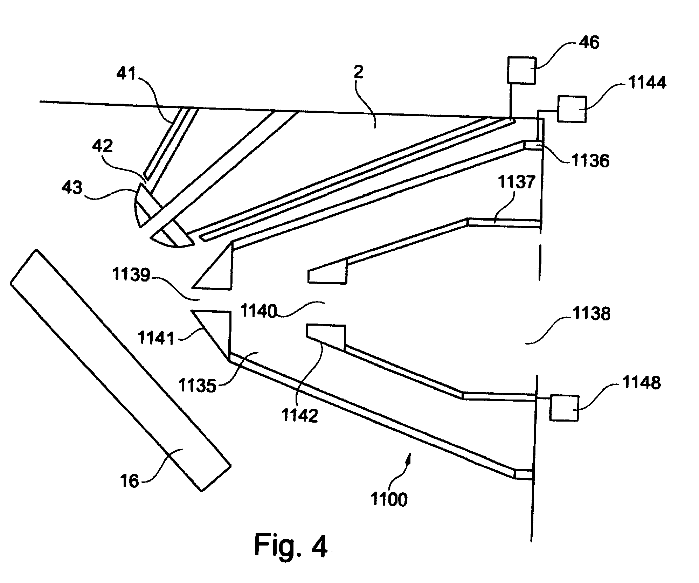

Figure 4 shows a detailed schematic illustration of an area as shown in Figure 2, specifically the area of the sample 16. The figure shows the extraction unit 1100 and that end of the first particle beam column 2 which is arranged in the area of the sample 16. The secondary ions are emitted virtually throughout the entire hemisphere facing away from the sample 16 and have a non-uniform kinetic energy, that is to say the kinetic energy is distributed. In order to allow a sufficient number of secondary ions to be evaluated, provision is made to inject secondary ions into the particle analysis apparatus 1000 by means of the extraction unit 1100. The extraction unit 1100 has a first extractor electrode 1136 which is in the form of a first hollow body. This is provided with a first inlet opening 1139 and a first cavity 1135. A second extractor electrode 1137, which is in the form of a second hollow body, is arranged in the first cavity 1135 and has a second inlet opening 1140 and a second cavity 1138. In the exemplary embodiment illustrated here, that end of the first particle beam column 2 which is arranged in the area of the sample 16 is provided with a control electrode 41. Provision is made for the control electrode 41 to partially or completely surround the first particle beam column 2. Furthermore, the control electrode 41 is arranged in a recess 42 on an outer surface 43 of the first particle beam column 2. An outer surface of the control electrode 41 and the outer surface 43 of the first particle beam column 2 form a continuous surface. It is explicitly noted that the invention is not restricted to an arrangement of the control electrode 41 such as this. In fact, any suitable arrangement of the control electrode 41 may be used. For example, the control electrode can be placed on the outer surface 43 of the first particle beam column 2.

As mentioned above, the illustration in Figure 4 should be regarded as a schematic illustration. The individual elements shown in Figure 4 are illustrated in a greatly exaggerated form, in order to illustrate them better. It is noted that, in particular, the first cavity 1135 may be quite small, in particular such that the distance between the second inlet opening 1140 and the first inlet opening 1139 is quite short (for example in the range from 1 mm to 15 mm, in particular 10 mm).

The first extractor electrode 1136 is at a first extractor potential. A first extractor voltage is a first potential difference between the first extractor potential and the sample potential. In this exemplary embodiment, ground potential (0 V) is used as the sample potential, although the sample potential is not restricted to ground potential. In fact, it may also assume a different value. The first extractor voltage, and therefore the first extractor potential, can be adjusted by means of a first voltage supply unit 1144.

Provision is also made for the second extractor electrode 1137 to be at a potential, specifically at a second extractor potential. A second extractor voltage is a second potential difference between the second extractor potential and the sample potential. The second extractor voltage and therefore the second extractor potential can be adjusted by means of a second voltage supply unit 1148. The first extractor potential and the second extractor potential may be of the same magnitude. In further embodiments, the first extractor potential and the second extractor potential have different magnitudes.

In a further embodiment, a first end section 1141 of the first extractor electrode 1136 is at the first extractor potential, while in contrast the rest of the first extractor electrode 1136 is at a potential which differs from this (for example ground potential). It is also possible for a second end section 1142 of the second extractor electrode 1137 to be at the second extractor potential while, in contrast, the rest of the second extractor electrode 1137 is at a potential which is different from this (for example ground potential).

The control electrode 41 is also at a potential, specifically the control electrode potential. A control electrode voltage is a third potential difference between the control electrode potential and the sample potential. The control electrode voltage and therefore the control electrode potential can be adjusted by means of a third voltage supply unit 46.

A somewhat similar situation applies to the terminating electrode 25 for the second particle beam column 3. The terminating electrode 25 is at a potential, specifically the terminating electrode potential. A terminating electrode voltage is a fourth potential difference between the terminating electrode potential and the sample potential. The terminating electrode voltage and therefore the terminating electrode potential can be adjusted by means of a fourth voltage supply unit 47 (cf. **Figure 2**).

The sample potential, the first extractor potential, the second extractor potential, the control electrode potential and/or the terminating electrode potential are now matched to one another such that an extraction field is generated, which ensures that a sufficient quantity of first interaction particles in the form of secondary ions passes through the first inlet opening 1139 in the first cavity 1135 of the first extractor electrode 1136, and through the second inlet opening 1140 in the second cavity 1138 of the second extractor electrode 1137.

Hard-vacuum conditions are used to generate the secondary ions by means of the ion beam. Since - as is also explained in more detail further below - the apparatus for energy transmission 1200 is operated in soft-vacuum conditions, the first extractor electrode 1136 and the second extractor electrode 1137 each have the function of a pressure stage. The larger the first inlet opening 1139 is in the first extractor electrode 1136, the more secondary ions can be injected into the particle analysis apparatus 1000. The same situation applies to the second inlet opening 1140 in the second extractor electrode 1137. However, if the first inlet opening 1139 and/or the second inlet opening 1140 are/is quite large, this reduces the effect of the first extractor electrode 1136 and of the second extractor electrode 1137, which act as pressure stages. Furthermore, the extraction field is also reduced. This can be compensated for by additionally amplifying the extraction field. However, this could lead to the secondary ions being supplied with additional kinetic energy.

Furthermore, the second extractor electrode 1137 is used to introduce the secondary ions into the downstream apparatus for energy transmission 1200, focused as well as possible. It has been found that a focusing effect of the second extractor electrode 1137 becomes greater the higher the second extractor potential is chosen to be.

As already mentioned above, the sample potential in this embodiment is ground potential. Furthermore, the first extractor potential and/or the second extractor potential are/is in the range from (-20) V to (-500) V, the control electrode potential is in the range from 200 V to 800 V, and/or the terminating electrode potential is in the range from (0 V) to (-120 V).

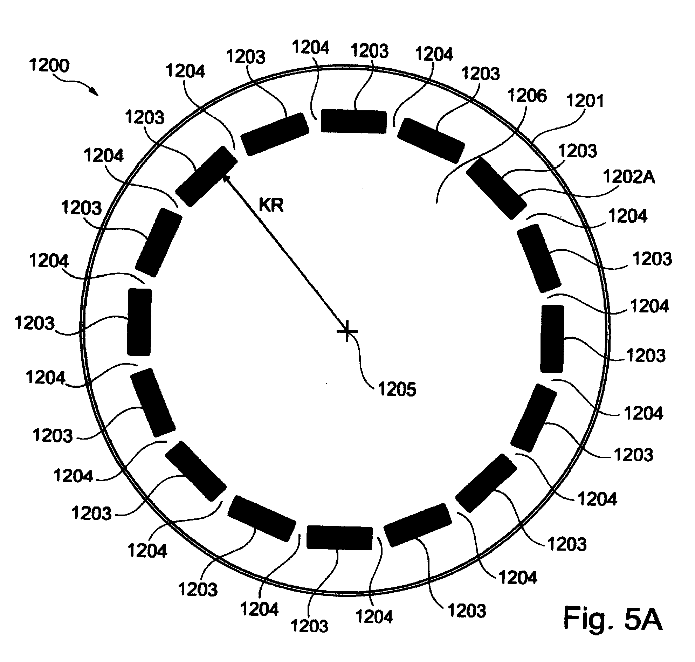

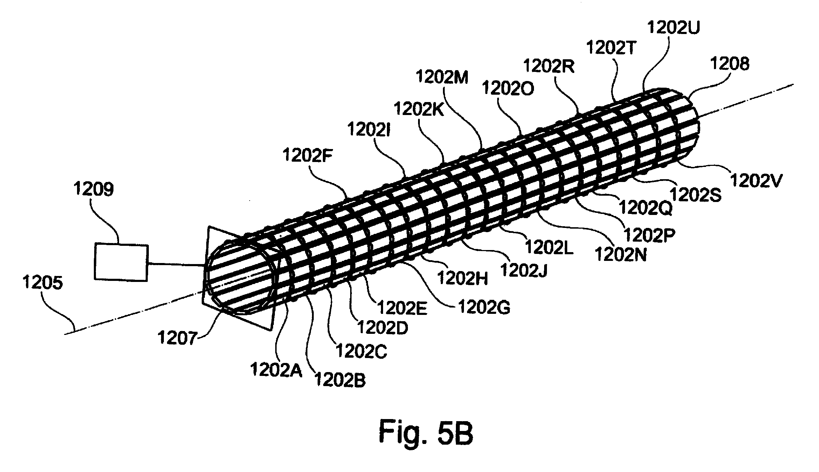

**Figures 5A and 5B** show a schematic illustration of the apparatus for energy transmission 1200. As will be explained in more detail in the following text, it is also used to transport secondary ions.

The apparatus for energy transmission 1200 has a tubular container 1201, which has a first container end 1207 and an area 1208 of a segment (twenty second segment 1202V), which will be explained further below. Along a transport axis in the form of a first longitudinal axis 1205, the tubular container 1201 has a longitudinal extent which is in the range from 100 mm to 500 mm, or in the range from 200 mm to 400 mm. For example, the tubular container 1201 has a longitudinal extent of 350 mm.

The first container end 1207 is connected to the extraction unit 1100. In contrast, the area 1208 is arranged on the ion transmission unit 1300.

The tubular container 1201 has a first internal area 1206. A flexible printed circuit board is arranged on one wall of the first internal area 1206 and is subdivided along the first longitudinal axis 1205 of the tubular container 1201 into numerous segments, specifically into a first segment 1202A, a second segment 1202B, a third segment 1202C, a fourth segment 1202D, a fifth segment 1202E, a sixth segment 1202F, a seventh segment 1202G, an eighth segment 1202H, a ninth segment 12021, a tenth segment 1202J, an eleventh segment 1202K, a twelfth segment 1202L, a thirteenth segment 1202M, a fourteenth segment 1202N, a fifteenth segment 12020, a sixteenth segment 1202P, a seventeenth segment 1202Q, an eighteenth segment 1202R, a nineteenth segment 1202S, a twentieth segment 1202T, a twenty first segment 1202U, and a twenty second segment 1202V. Each of the abovementioned segments has printed circuit board electrodes 1203, which are arranged on the flexible printed circuit board. The material from which the flexible printed circuit board is formed is non-conductive. An insulation element 1204 is in each case arranged between two printed circuit board electrodes 1203, and is formed from the non-conductive material. By way of example, the first segment 1202A, which is shown in **Figure 5B**, is illustrated in the form of a section drawing in **Figure 5A**. The printed circuit board electrodes 1203 and the insulation elements 1204 are arranged over the entire circumference of the first internal area 1206.

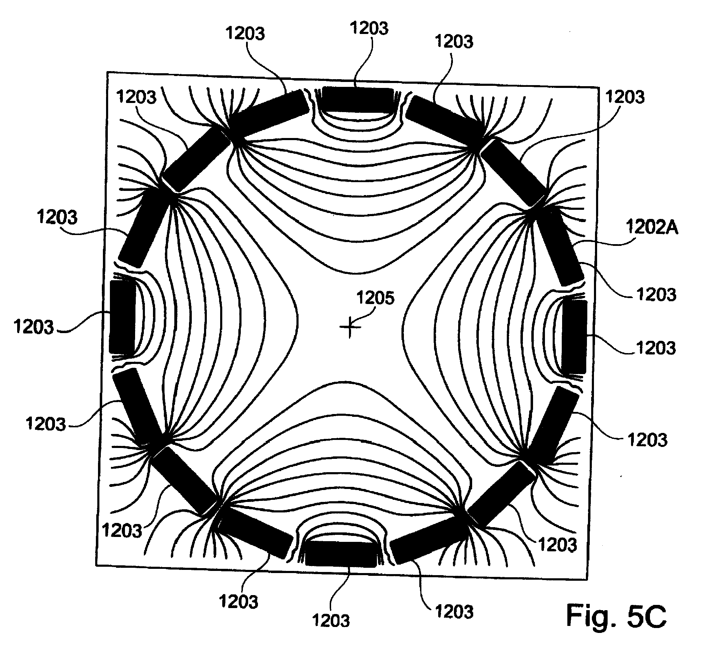

Each individual one of the abovementioned segments 1202A to 1202V in its own light represents a quadrupole unit, which electrically simulates a quadrupole alternating field. This means that one segment 1202A to 1202V in each case generates a quadrupole alternating field by the application of potentials to the printed circuit electrodes 1203 of the individual abovementioned segments 1202A to 1202V. In this case, each of the abovementioned segments 1202A to 1202V is designed such that the quadrupole alternating field of each of the abovementioned segments 1202A to 1202V is identical. **Figure 5C** shows a schematic illustration of the quadrupole alternating field with lines of equipotential for the first segment 1202A.

In particular, contact is made with individual elements of the flexible printed circuit board via conductor tracks which are arranged in the flexible printed circuit board and are already present. This is a simple form of connection.

At this point, it is expressly noted that the invention is not restricted to the use of a single flexible printed circuit board. In fact, the invention also allows the use of a plurality of flexible printed circuit boards. For example, individual ones or all of the abovementioned segments 1202A to 1202V may each be formed from a flexible printed circuit board.

The first internal area 1206 of the tubular container 1201 is circular and has a core radius KR. The core radius KR is, for example, in the range from 2 mm to 50 mm, or in the range from 8 mm to 20 mm, or in the range from 9 mm to 12 mm. By way of example, the core radius KR is 15 mm, 10 mm, 9 mm or 8 mm.

Each individual one of the abovementioned segments 1202A to 1202V has a longitudinal extent in the direction of the first longitudinal axis 1205, which may correspond approximately to the core radius KR. As mentioned above, the length of the segments should be oriented on the core radius. The arrangement of the printed circuit board electrodes 1203 as described above allows a larger core radius KR to be achieved than in the case of known systems from the prior art, which use bar electrodes.

The first internal area 1206 of the tubular container 1201 is filled with a gas which has gas particles. The partial pressure of the gas in the first internal area 1206 can be adjusted by means of a supply device, which is not illustrated.

The secondary ions which enter the first internal area 1206 of the tubular container 1201 from the extraction unit 1100 transmit a portion of their kinetic energy to the neutral gas particles by means of impacts. This decreases the energy of the secondary ions. The secondary ions are braked. In order to achieve a sufficiently high impact rate to reduce the energy, there is a soft vacuum, for example in the region of $5 \times 10^{-3}$ mbar ($5 \times 10^{-1}$ Pa), in the first internal area 1206 of the tubular container 1201. The higher the partial pressure of the gas in the first internal area 1206 of the tubular container 1201 is, the greater is the impact rate, and accordingly also the capability to transmit energy from the secondary ions to the gas particles. After passing through the tubular container 1201 from the first container end 1207 to the area 1208, the secondary ions generally still have only thermal energy.

A further embodiment additionally or alternatively provides for the secondary ions which enter the first internal area 1206 of the tubular container 1201 from the extraction unit 1100 to strike the neutral gas particles and to be fragmented, thus likewise reducing the energy of the secondary ions. This process also results in braking of the secondary ions.

As mentioned above, the kinetic energy of the secondary ions can be subdivided on the one hand into a radial component and on the other hand into an axial component. The radial component causes the secondary ions to diverge radially with respect to the first longitudinal axis 1205 of the tubular container 1201. This divergence is reduced by means of the quadrupole alternating field. The quadrupole alternating field results in the secondary ions being stored in a small radius around the first longitudinal axis 1205, along the first longitudinal axis 1205 of the tubular container 1201. To be more precise, the impacts of the secondary ions with the gas particles and/or the fragmentation mentioned above result/results in the radial component of the kinetic energy being reduced, as a result of which the amplitude of the above mentioned macro-oscillation is reduced, and the secondary ions are focused onto the first longitudinal axis 1205 of the tubular container 1201.

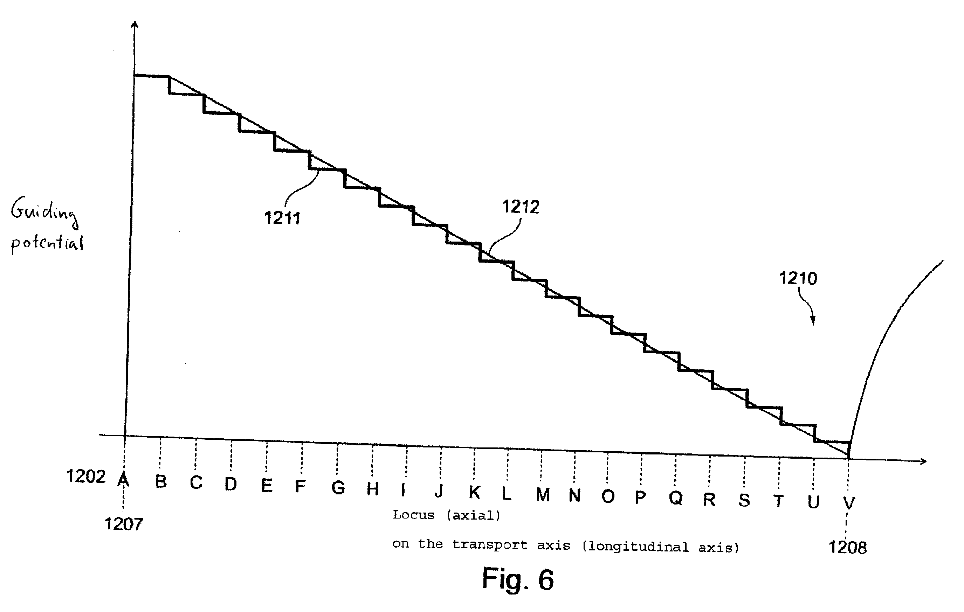

The axial component of the kinetic energy ensures that the secondary ions pass through the tubular container 1201 along the first longitudinal axis 1205 of the tubular container 1201 in the direction of the ion transmission unit 1300. The abovementioned impacts and/or the abovementioned fragmentation also reduce the axial kinetic energy, however, as a result of which the energy of some secondary ions is no longer sufficient to pass completely through the tubular container 1201. Each individual one of the abovementioned segments 1202A to 1202V is therefore connected to a second electronic circuit 1209 (cf. **Figure 5B**) such that a guiding potential gradient is produced along the first longitudinal axis 1205 of the tubular container 1201, with a guiding potential associated with that point being provided at each point on the first longitudinal axis 1205. The secondary ions are moved axially along the first longitudinal axis 1205 in the direction of the area 1208 of the tubular container 1201 by means of the guiding potential gradient. The guiding potential gradient is designed such that the guiding potential decreases continuously in the direction of the area 1208, and has a potential well 1210 in the area 1208. **Figure 6** shows the profile of the guiding potential 1212. The graph shows the guiding potential 1212 as a function of the locus along the first longitudinal axis 1205. A respectively different potential, which is constant over time, is applied to the printed circuit board electrodes of each of the abovementioned segments 1202A to 1202V which are arranged along the transport axis (in this case the first longitudinal axis 1205). This is illustrated by the stepped profile of the segment potentials 1211 in Figure 6. The stepped profile results essentially in the profile of the guiding potential 1212. The guiding potential 1212 is at its maximum at the first container end 1207 of the tubular container 1201, and decreases continuously in the direction of the area 1208. The potential well 1210 is provided in the area 1208 of the tubular container 1201. The secondary ions pass through the tubular container 1201 and in the process transmit their energy to the gas particles, until they remain in the potential well 1210. It is explicitly noted that the potential well 1210 can also be provided at a different point. For example, in a further exemplary embodiment, the potential well 1210 is arranged behind the area 1208, in the area of the ion transmission unit 1300. The only important factor is that the secondary ions transmit their energy as they pass through the tubular container 1201, and rest in the potential well 1210.

The amplitude of the macro-oscillation can be reduced by transmission of a sufficiently large amount of energy from the secondary ions to the gas particles. In contrast, the amplitude of the micro-oscillation can be reduced by increasing the frequency of the quadrupole alternating field of each of the individual ones of the abovementioned segments 1202A to 1202V. However, this reduces the restoring forces acting on the secondary ions in the tubular container 1201, as a result of which a greater amplitude of the quadrupole alternating field is required in order to reliably store the secondary ions in the tubular container 1201.

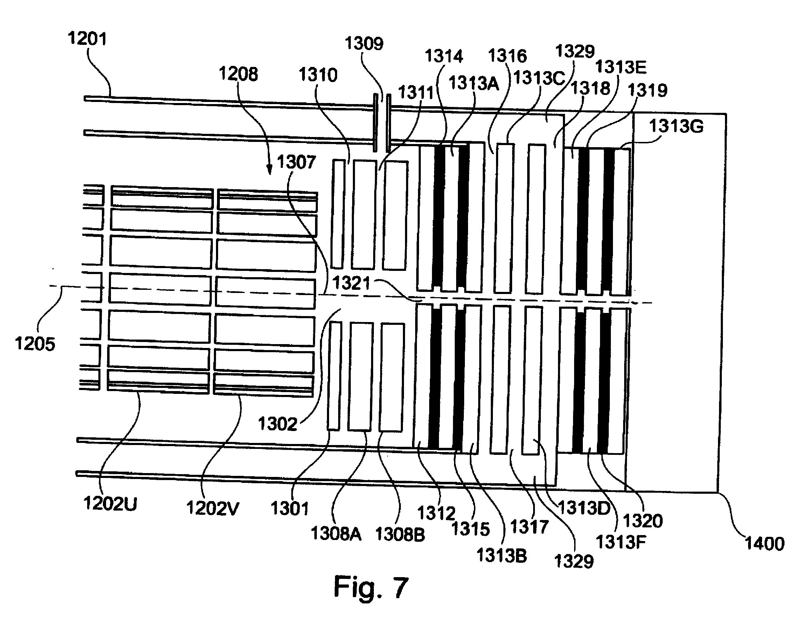

**Figure 7** shows the area 1208, in which case the abovementioned segments 1202A to 1202V are in this embodiment not arranged directly adjacent to the inner wall of the tubular container 1201. As is shown in **Figure 7**, a first quadrupole disk 1301 is arranged in the area 1208. The first quadrupole disk 1301 is multi-hyperbolic. This means that it is provided with a multiplicity of hyperbolic printed circuit board electrodes. As an alternative to this, the printed circuit board electrodes are semicircular. The first quadrupole disk 1301 is in the form of a disk. An embodiment in the form of a disk means that the hyperbolic printed circuit board electrodes are formed by a planar structure which is aligned at right angles to the transport axis (in the form of the first longitudinal axis 1205 or a second longitudinal axis 1307). The first quadrupole disk 1301 has a predeterminable extent along the transport axis. This will be explained in more detail in the following text. In the exemplary embodiment described here, the first quadrupole disk 1301 is provided with twelve hyperbolic printed circuit board electrodes.

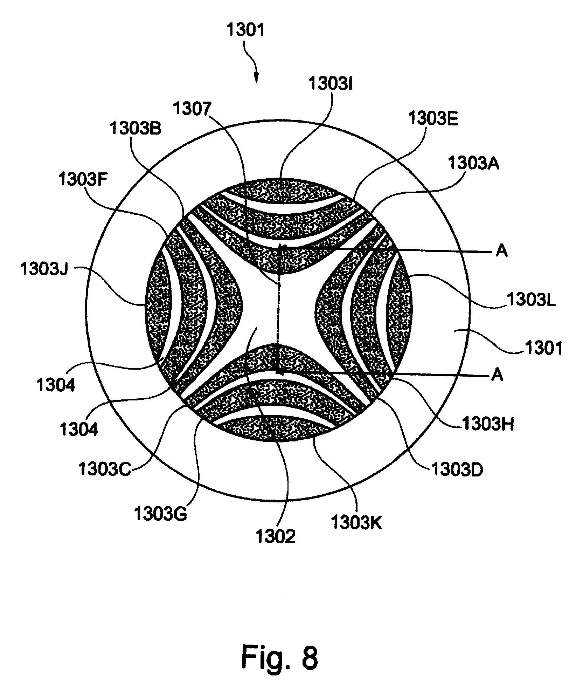

**Figure 8** shows a plan view of the first quadrupole disk 1301. The first quadrupole disk 1301 has a first hyperbolic printed circuit board electrode 1303A, a second hyperbolic printed circuit board electrode 1303B, a third hyperbolic printed circuit board electrode 1303C, a fourth hyperbolic printed circuit board electrode 1303D, a fifth hyperbolic printed circuit board electrode 1303E, a sixth hyperbolic printed circuit board electrode 1303F, a seventh hyperbolic printed circuit board electrode 1303G, an eighth hyperbolic printed circuit board electrode 1303H, a ninth hyperbolic printed circuit board electrode 1303I, a tenth hyperbolic printed circuit board electrode 1303J, an eleventh hyperbolic printed circuit board electrode 1303K and a twelfth hyperbolic printed circuit board electrode 1303L. As mentioned above, all the abovementioned printed circuit board electrodes 1303A to 1303L are hyperbolic. Both in the text above and that below as well, this means that two hyperbolic electrodes (in this case the printed circuit board electrodes 1303A to 1303L) which are arranged opposite one another and whose apex points are at the same distance from the transport axis (in this case the second longitudinal axis 1307) (for example the first hyperbolic printed circuit board electrode 1303A and the third hyperbolic printed circuit board electrode 1303C) comply with the hyperbola equation:

$$\frac{x^2}{a^2} - \frac{y^2}{b^2} = 1 \quad [3]$$

where x and y are Cartesian coordinates and a and b are the distances between the apex points of the respective electrodes and the transport axis. Adjacent printed circuit board electrodes are each isolated from one another by an insulating layer 1304, as is illustrated by way of example in **Figure 8** for the second hyperbolic printed circuit board electrode 1303B, for the sixth hyperbolic printed circuit board electrode 1303F and for the tenth hyperbolic printed circuit board electrode 1303J. However, the situation is also identical for each of the further abovementioned printed circuit board electrodes 1303A, 1303E, 1303I, 1303C, 1303G, 1303K, 1303D, 1303H and 1303L. Furthermore, adjacent hyperbolic printed circuit board electrodes are driven, for example, by means of capacitive voltage dividers (not illustrated) such that a quadrupole alternating field is generated. However, the invention is not restricted to the use of capacitive voltage dividers. In fact, any suitable drive can be used, for example in each case by means of one power supply unit for each of the abovementioned hyperbolic printed circuit board electrodes 1303A to 1303L.

The first quadrupole disk 1301 has a first through-opening 1302 which is bounded by an apex point of the first hyperbolic printed circuit board electrode 1303A, an apex point of the second hyperbolic printed circuit board electrode 1303B, an apex point of the third hyperbolic printed circuit board electrode 1303C and an apex point of the fourth hyperbolic printed circuit board electrode 1303D. The use of a printed circuit board for the first quadrupole disk 1301 is particularly advantageous, because it is simple to manufacture. For example, the first through-opening 1302 can be produced with little effort, for example by milling out the printed circuit board. The first through-opening 1302 has an extent in the radial direction with respect to the transport axis, which continues with respect to the first longitudinal axis 1205 of the tubular container 1201, in the form of the second longitudinal axis 1307 of the first through-opening 1302. The extent is in this case the distance between two of the abovementioned apex points which are arranged opposite one another, with the extent being in at least one of the following ranges: from 0.2 mm to 10 mm, from 0.2 mm to 5 mm, or from 0.2 mm to 1 mm.

The first hyperbolic printed circuit board electrode 1303A, the second hyperbolic printed circuit board electrode 1303B, the third hyperbolic printed circuit board electrode 1303C and the fourth hyperbolic printed circuit board electrode 1303D are at the same radial distance from the second longitudinal axis 1307 of the first through-opening 1302, and are each at a first radial distance from the second longitudinal axis 1307 of the first through-opening 1302, in which case, in the above text and in the following text as well, the radial distance is defined by the distance between the apex point, arranged closest to the second longitudinal axis 1307, of a respective hyperbolic printed circuit board electrode and the second longitudinal axis 1307 of the first through-opening 1302. Furthermore, the fifth hyperbolic printed circuit board electrode 1303E, the sixth hyperbolic printed circuit board electrode 1303F, the seventh hyperbolic printed circuit board electrode 1303G and the eighth hyperbolic printed circuit board electrode 1303H are at the same radial distance from the second longitudinal axis 1307 of the first through-opening 1302, and are each at a second radial distance from the second longitudinal axis 1307 of the first through-opening 1302. Furthermore, the ninth hyperbolic printed circuit board electrode 13031, the tenth hyperbolic printed circuit board electrode 1303J, the eleventh hyperbolic printed circuit board electrode 1303K and the twelfth hyperbolic printed circuit board electrode 1303L are at the same radial distance from the second longitudinal axis 1307 of the first through-opening 1302, and are each at a third radial distance from the second longitudinal axis 1307 of the first through-opening 1302. The first radial distance is less than the second radial distance. The second radial distance is once again less than the third radial distance.

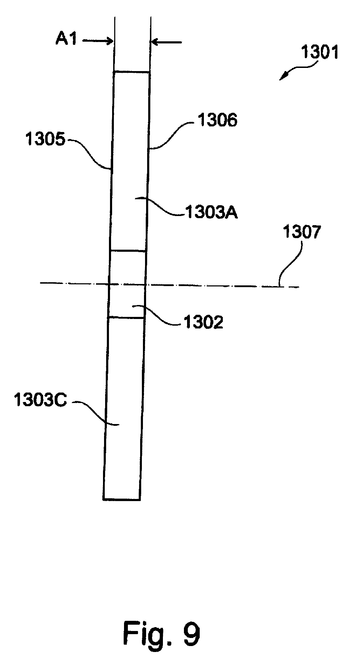

Figure 9 shows a section illustration of the first quadrupole disk 1301 along the line A-A shown in Figure 8. This schematically illustrates the first hyperbolic printed circuit board electrode 1303A and the third hyperbolic printed circuit board electrode 1303C. The first quadrupole disk 1301 has a first outer surface 1305 and a second outer surface 1306. The first outer surface 1305 and the second outer surface 1306 are separated from one another such that there is a distance A1 between the first outer surface 1305 and the second outer surface 1306 in one of the ranges mentioned in the following text: from 1 mm to 50 mm, from 1 mm to 40 mm, from 1 mm to 30 mm, from 1 mm to 20 mm, or from 1 mm to 5 mm. Even though this is not illustrated explicitly, each of the abovementioned hyperbolic printed circuit board electrodes 1303A to 1303L is arranged on the plane which is formed by the first outer surface 1305, and each may extend from the first outer surface 1305 to the second outer surface 1306.

As can be seen from Figure 7, the first quadrupole disk 1301 is followed by a first quadrupole device 1308A in the form of a disk and by a second quadrupole device 1308B in the form of a disk. In this case, an embodiment in the form of a disk of each abovementioned quadrupole device and each quadrupole device which is also mentioned in the following text means that the electrode devices which are also explained in the following text are formed by a planar structure which is aligned at right angles to the transport axis (in this case the second longitudinal axis 1307). The first quadrupole device 1308A in the form of a disk and the second quadrupole device 1308B in the form of a disk each have four hyperbolic electrode devices in this exemplary embodiment, which each produce a quadrupole alternating field. As an alternative to this, the electrode devices are semicircular. A gas inlet 1309 is arranged at the same height as the first quadrupole device 1308A in the form of a disk and the second quadrupole device 1303B in the form of a disk, through which gas inlet 1309 the gas flows in in order then to interact with the secondary ions, as already explained above. Both the first quadrupole device 1308A in the form of a disk and the second quadrupole device 1308B in the form of a disk have a through-opening which corresponds to the first through-opening 1302.

A first intermediate area 1310 between the first quadrupole disk 1301 and the first quadrupole device 1308A in the form of a disk, as well as a second intermediate area 1311 between the first quadrupole device 1308A in the form of a disk and the second quadrupole device 1308B in the form of a disk are not sealed, thus allowing the gas to be distributed, in particular into the area with the abovementioned segments 1202A to 1202V.

The first quadrupole disk 1301, the first quadrupole device 1308A in the form of a disk and the second quadrupole device 1308B in the form of a disk are on the one hand parts of the apparatus for energy transmission 1200. This means that energy can also be transmitted from the secondary ions to neutral gas particles in the area of the first quadrupole disk 1301, of the first quadrupole device 1308A in the form of a disk and of the second quadrupole device 1308B in the form of a disk. On the other hand, the first quadrupole disk 1301, the first quadrupole device 1308A in the form of a disk and the second quadrupole device 1308B in the form of a disk are also part of the ion transmission unit 1300, however, as will also be explained in more detail further below.

The first quadrupole disk 1301 has at least two functions. On the one hand, the first quadrupole disk 1301 may have a suitable potential applied to it (referred to in the following text as the mirror potential). This makes it possible for secondary ions which have not yet been braked to thermal energy to be reflected back from the first quadrupole disk 1301 into the tubular container 1201, such that they pass through the tubular container 1201 once again. This once again results in impacts in the tubular container 1201 with the gas particles, as a result of which these reflected secondary ions furthermore transmit energy to the neutral gas particles. The guiding potential mentioned above ensures that these secondary ions are once again transported in the direction of the area 1208. The mirror potential is switched off as soon as the secondary ions have been brought to thermal energy.

On the other hand, the first quadruple disk 1301 is used for focusing secondary ions onto the second longitudinal axis 1307. A potential pulse can be used to lift the secondary ions located in the abovementioned potential well 1210 at the guiding potential into the first through-opening 1302. In an alternative embodiment, the abovementioned potential well 1210 is formed in the area of the first quadrupole disk 1301, the first quadrupole device 1308A in the form of a disk or the second quadrupole device 1308B in the form of a disk.

The first quadrupole disk 1301 ensures that a quadrupole alternating field which stores the secondary ions is made available such that the secondary ions are focused radially in the area of the second longitudinal axis 1307. By way of example, the secondary ions are focused within a small radius of, for example, in the range from 0.2 mm to 5 mm around the second longitudinal axis 1307. This corresponds approximately to the radial extent of the first through-opening 1302. The first quadrupole disk 1301 can accordingly be used to create a transition between a first guide system for secondary ions with quite a large core radius (in this exemplary embodiment the tubular container 1201 with a core radius of, for example, in the range from 5 mm to 15 mm) and a second guide system (which will be explained in more detail further below) with a comparatively small core radius (for example in the range from 0.1 mm to 5 mm), without secondary ions being reflected back into the tubular container 1201 inadvertently at the first quadrupole disk 1301, or being neutralized on the first quadrupole disk 1301. Furthermore, the first quadrupole disk 1301 prevents axial components of the kinetic energy of the secondary ions being converted to radial components of the kinetic energy of the secondary ions.

In order to avoid loss of secondary ions as a result of the secondary ions striking one of the abovementioned hyperbolic printed circuit board electrodes 1303A to 1303D of the first quadrupole disk 1301, a total oscillation amplitude, which is the sum of the amplitude of the macro-oscillation and the amplitude of the micro-oscillation, should remain less than the radius of the first through-opening 1302. If this is not the case, then the first quadrupole disk 1301 has the mirror potential applied to it, such that the secondary ions pass through the tubular container 1201 once again, until they have been brought to thermal energy, as explained above. The first through-opening 1302 is designed such that secondary ions with thermal energy can pass through the first through-opening 1302 without having to meet one of the abovementioned hyperbolic printed circuit board electrodes 1303A to 1303D of the first quadrupole disk 1301.

As already explained above, the potential well 1210 in Figure 6 may also be provided at a different point. For example, in a further exemplary embodiment, the potential well 1210 is arranged behind the area 1208, in the area of the ion transmission unit 1300. By way of example, the potential well 1210 is formed in the area of the first quadrupole disk 1301, the first quadrupole device 1308A in the form of a disk or the second quadrupole device 1308B in the form of a disk. In this case, by way of example, the second quadrupole device 1308B in the form of a disk is provided with a terminating potential, which is used to generate a potential wall. This potential wall is, for example, part of the potential well 1210.

As can be seen from **Figure 7**, a second quadrupole disk 1312 is adjacent to the second quadrupole device 1308B in the form of a disk and is designed to be essentially identical to the first quadrupole disk 1301. However, this design is not absolutely essential. In fact, further embodiments provide for the second quadrupole disk 1312 to be designed, for example, in the same way as the second quadrupole device 1308B in the form of a disk. The second quadrupole disk 1312 is used for focusing the secondary ions onto the second longitudinal axis 1307, which extends through a second through-opening 1321 in the second quadrupole disk 1312. The second through-opening 1321 is smaller than the first through-opening 1302. By way of example, the extent of the second through-opening 1321 is in the range from 0.4 mm to 2 mm.

As mentioned above, the amplitude of the macro-oscillation can be reduced by transmitting a sufficiently large amount of energy from the secondary ions to the gas particles. In contrast, the amplitude of the micro-oscillation can be reduced by increasing the frequency of the quadrupole alternating field. However, this reduces the restoring forces acting on the secondary ions, as a result of which the quadrupole alternating field has to have a greater amplitude in order to reliably store the secondary ions. In order to keep the sudden frequency change between the individual core radii small, it is advantageous to reduce the core radius in two steps (specifically on the one hand with the first quadrupole disk 1301 and on the other hand with the second quadrupole disk 1312).

A third quadrupole device 1313A in the form of a disk, a fourth quadrupole device 1313B in the form of a disk, a fifth quadrupole device 1313C in the form of a disk, a sixth quadrupole device 1313D in the form of a disk, a seventh quadrupole device 1313E in the form of a disk, an eighth quadrupole device 1313F in the form of a disk and a ninth quadrupole device 1313G in the form of a disk are following the second quadrupole disk 1312 along the second longitudinal axis 1307. Each of the abovementioned quadrupole devices 1313A to 1313G in the form of disks in each case has a through-opening which is identical to the second through-opening 1321.

The third quadrupole device 1313A in the form of a disk, the fourth quadrupole device 1313B in the form of a disk, the fifth quadrupole device 1313C in the form of a disk, the sixth quadrupole device 1313D in the form of a disk, the seventh quadrupole device 1313E in the form of a disk, the eighth quadrupole device 1313F in the form of a disk and the ninth quadrupole device 1313G in the form of a disk each have a first electrode device, a second electrode device, a third electrode device and a fourth electrode device. The first electrode device, the second electrode device, the third electrode device and the fourth electrode device are all hyperbolic. Each of the abovementioned quadrupole devices 1313A to 1313G in the form of disks generates a quadrupole alternating field by means of the electrode devices associated with it.

The first quadrupole disk 1301, the second quadrupole disk 1312, the first quadrupole device 1308A in the form of a disk, the second quadrupole device 1308B in the form of a disk and the third quadrupole device 1313A in the form of a disk to the ninth quadrupole device 1313G in the form of a disk are parts of the ion transmission unit 1300, which will be described in more detail further below. Furthermore, the second quadrupole disk 1312 and the third quadrupole device 1313A in the form of a disk to the ninth quadrupole device 1313G in the form of a disk are additionally, however, also parts of a pressure stage, which will now be explained in following text.

A sufficiently high gas pressure such that the secondary ions can transmit energy to neutral gas particles by impacts is still present in the area of the first quadrupole disk 1301, of the first quadrupole device 1308A in the form of a disk, of the second quadrupole device 1308B in the form of a disk and of the second quadrupole disk 1312.

The second quadrupole disk 1312, the third quadrupole device 1313A in the form of a disk and the fourth quadrupole device 1313B in the form of a disk form a sealed system. For this purpose, a third intermediate area 1314 between the second quadrupole disk 1312 and the third quadrupole device 1313A in the form of a disk, as well as a fourth intermediate area 1315 between the third quadrupole device 1313A in the form of a disk and the fourth quadrupole device 1313B in the form of a disk are sealed by means of seals. The seals can be designed as required. By way of example, the seals are in the form of O-rings and/or are electrically insulating. Furthermore, for example, a free internal diameter of the seals can be made larger than the extent of the second through-opening 1321 in order to avoid charges.

The seventh quadrupole device 1313E in the form of a disk, the eighth quadrupole device 1313F in the form of a disk and the ninth quadrupole device 1313G in the form of a disk likewise form a sealed system. For this purpose, an eighth intermediate area 1319 between the seventh quadrupole device 1313E in the form of a disk and the eighth quadrupole device 1313F in the form of a disk, as well as a ninth intermediate area 1320 between the eighth quadrupole device 1313F in the form of a disk and the ninth quadrupole device 1313G in the form of a disk are sealed by means of seals. The above statements relating to the seals also apply here.

A fifth intermediate area 1316, which is in the form of a pumping-out channel, is arranged between the fourth quadrupole device 1313B in the form of a disk and the fifth quadrupole device 1313C in the form of a disk. Furthermore, a sixth intermediate area 1317, which is likewise in the form of a pumping-out channel, is arranged between the fifth quadrupole device 1313C in the form of a disk and the sixth quadrupole device 1313D in the form of a disk. A seventh intermediate area 1318, which is in the form of a pumping-out channel, is also arranged between the sixth quadrupole device 1313D in the form of a disk and the seventh quadrupole device 1313E in the form of a disk. The abovementioned pumping-out channels are connected via channels 1329 to a pump unit (not illustrated). This is particularly advantageous when gas particles enter the ion transmission unit 1300 from the tubular container 1201. The gas particles are then removed by means of the pump unit via the abovementioned pumping-out channels, such that they essentially cannot enter the analysis unit 1400.

Furthermore, each of the abovementioned quadrupole devices 1313A to 1313G in the form of disks is in each case formed from a printed circuit board.

The second through-opening 1321 has an extent which is in one of the following ranges: from 0.4 mm to 10 mm, from 0.4 mm to 5 mm, or from 0.4 mm to 2 mm.

The splitting of a pressure stage by means of the arrangement as described above of the second quadrupole disk 1312, and the abovementioned quadrupole devices 1313A to 1313G which are in the form of disks, in order to generate quadrupole alternating fields ensures that, on the one hand, the secondary ions can be focused in a small area around the second longitudinal axis 1307, and on the other hand that good pressure stage characteristics are achieved. The pressure stage extends essentially over a large proportion of the ion transmission unit 1300.

All of the elements of the ion transmission unit 1300 also have a further function, which will be described in the following text.

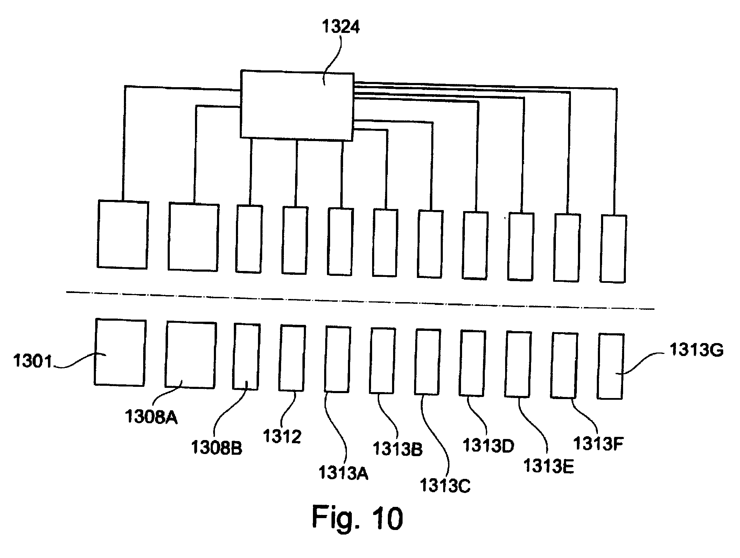

**Figure 10** once again shows a schematic section illustration of the described elements of the ion transmission unit 1300. The first quadrupole disk 1301, the second quadrupole disk 1312 and also each of the quadrupole devices 1308A, 1308B as well as 1313A to 1313G in the form of disks are each provided with an individual potential, by means of an electronic circuit 1324. The first quadrupole disk 1301 is therefore provided with a first potential, the second quadrupole disk 1312 with a second potential, the first quadrupole device 1308A in the form of a disk with a third potential, the second quadrupole device 1308B in the form of a disk with a fourth potential, the third quadrupole device 1313A in the form of a disk with a fifth potential, the fourth quadrupole device 1313B in the form of a disk with a sixth potential, the fifth quadrupole device 1313C in the form of a disk with a seventh potential, the sixth quadrupole device 1313D in the form of a disk with an eighth potential, the seventh quadrupole device 1313E in the form of a disk with a ninth potential, the eighth quadrupole device 1313F in the form of a disk with a tenth potential, and the ninth quadrupole device 1313G in the form of a disk with an eleventh potential. The first potential to the eleventh potential can each be set individually.

The quadrupole alternating fields provided in the ion transmission unit 1300 as well as the abovementioned, individually adjustable, first to eleventh potentials, make it possible for the secondary ions which are braked to a thermal energy to be transported into the analysis unit 1400 without kinetic energy being significantly supplied to the secondary ions. For this purpose, the adjustable first to eleventh potentials which are provided in addition to the individual quadrupole alternating fields are set such that potential wells are created. This and the transport will now be explained with reference to a plurality of exemplary embodiments.

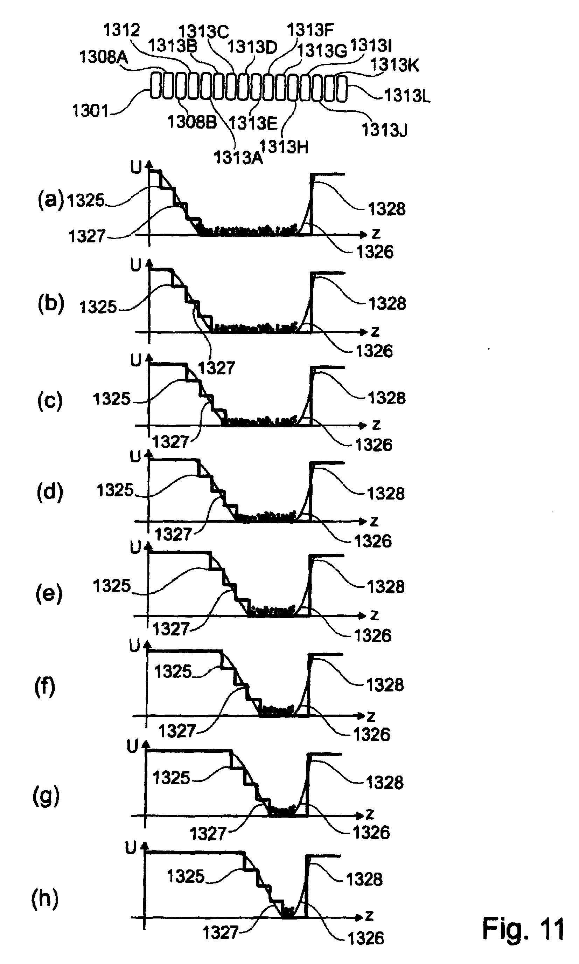

**Figure 11** first of all shows a schematic illustration of the first quadrupole disk 1301, the second quadrupole disk 1312 and the quadrupole devices 1308A, 1308B as well as 1313A to 1313G which are in the form of disks. Furthermore, further quadrupole devices in the form of disks are provided, specifically a tenth quadrupole device 1313H in the form of a disk, an eleventh quadrupole device 1313I in the form of a disk, a twelfth quadrupole device 1313J in the form of a disk, a thirteenth quadrupole device 1313K in the form of a disk and a fourteenth quadrupole device 1313L in the form of a disk. The abovementioned quadrupole devices 1313H to 1313L in the form of disks are also each provided with an individual potential by means of an electronic circuit, for example the electronic circuit 1324. The tenth quadrupole device 1313H in the form of a disk is therefore provided with a twelfth potential, the eleventh quadrupole device 1313I in the form of a disk with a thirteenth potential, the twelfth quadrupole device 1313J in the form of a disk with a fourteenth potential, the thirteenth quadrupole device 1313K in the form of a disk with a fifteenth potential, and the fourteenth quadrupole device 1313L in the form of a disk with a sixteenth potential. The twelfth potential to the sixteenth potential may each be set individually. This is intended to illustrate that the ion transmission unit 1300 can always have more or else fewer than the units illustrated in **Figure 7**. The fourteenth quadrupole device 1313L in the form of a disk is then followed by the analysis unit 1400 which, for example, is arranged detachably on the ion transmission unit 1300. However, all of these embodiments always operate in the same way, as will now be explained in the following text.

As explained above, the first to the sixteenth potentials can each be set individually. For this purpose, the corresponding potentials are respectively applied to the individual corresponding quadrupole disks 1301, 1312 and quadrupole devices 1308A, 1308B as well as 1313A to 1313L which are in the form of disks. By way of example, they are set such that the first to the sixteenth potentials are different to one another. The adjustment process is also carried out, for example, by use of charging processes when switching from a first potential value to a second potential value. The adjustment process makes it possible to achieve a specific potential profile in the ion transmission unit 1300. **Figures 11a to 11h** show the time profile of the total potential, which is composed of the first to the sixteenth potentials, in the ion transmission unit 1300, with **Figure 11a** showing the earliest instantaneous record of the total potential in time and **Figure 11h** showing the latest instantaneous record of the total potential in time. The graph shows the potential as a function of the locus on the second longitudinal axis 1307. The reference symbol 1325 denotes a stepped potential profile which occurs when considering one moment in the profile of the total potential. The reference symbol 1326 denotes the ideal potential profile. The first to sixteenth potentials are each switched such that the illustrated profile of the total potential is achieved. The maximum total potential in the exemplary embodiment illustrated here is in the range of a few volts, for example 2 V to 3 V. First of all, **Figure 11a** shows a potential well, where a left-hand flank 1327 of the potential well is configured such that the secondary ions which still have only thermal energy can fall into the potential well from the area of the first quadrupole disk 1301. A right-hand flank 1328, which is provided in the area of the eleventh quadrupole device 1313I in the form of a disk and the twelfth quadrupole device 1313J in the form of a disk, is designed to be sufficiently steep that the secondary ions can no longer leave the potential well on the right-hand flank 1328. The left-hand flank 1327 is also designed such that the secondary ions can no longer leave the potential well, with the gas pressure in this area still being sufficiently high that the secondary ions can transmit energy to neutral gas particles by impacts. This ensures that the secondary ions can no longer leave the potential well. The state in **Figure 11a** is now maintained for a predetermined time (for example in the region of a few milliseconds). The secondary ions are collected in the potential well (accumulation of the secondary ions) in this predetermined time (accumulation time). The first to sixteenth potentials are now switched such that the left-hand flank 1327 migrates to the right-hand flank 1328 (**Figures 11b to 11h**). In consequence, the potential well becomes ever narrower. The secondary ions are likewise forced to move in the direction of the right-hand flank 1328 by this movement of the left-hand flank 1327. In this way, the secondary ions are transported in the ion transmission unit 1300. The first to sixteenth potentials are now switched such that the left-hand flank 1327 and the right-hand flank 1328 are moved along the second longitudinal axis 1307 such that the secondary ions in the potential well move slightly in front of the analysis unit 1400.

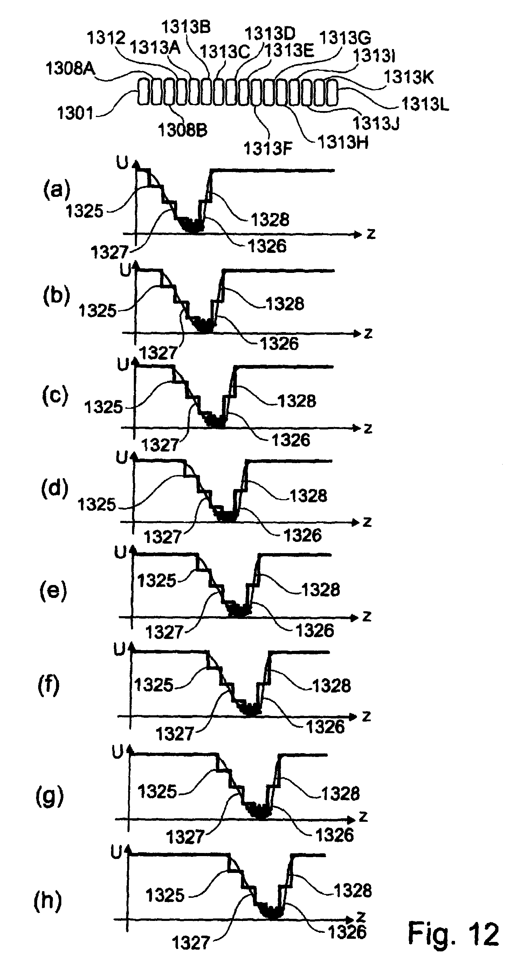

**Figure 12** shows a further exemplary embodiment of how the secondary ions are transported in the ion transmission unit 1300. **Figure 12** is based on **Figure 11**, as a result of which reference is made first of all to all the above statements. **Figures 12a to 12h** show the time profile of the total potential, which is composed of the first to sixteenth potentials, in the ion transmission unit 1300, with **Figure 12a** showing the earliest instantaneous record of the total potential in time, and **Figure 12h** showing the latest instantaneous record of the total potential in time. The maximum total potential is in this case once again in the region of a few volts, for example 2 V to 3 V. First of all, a potential well is illustrated in **Figure 12a**, with the left-hand flank 1327 of the potential well being designed such that the secondary ions which still have only thermal energy can fall into the potential well from the area of the first quadrupole disk 1301. The right-hand flank 1328, which is provided in the area of the third quadrupole device 1313A in the form of a disk and the fourth quadrupole device 1313B in the form of a disk, is designed to be sufficiently steep that the secondary ions can no longer leave the potential well on the right-hand flank 1328. The left-hand flank 1327 is also designed such that the secondary ions can no longer leave the potential well, with the gas pressure in this area still being sufficiently high that the secondary ions can transmit energy to neutral gas particles by impacts. This ensures that the secondary ions can no longer leave the potential well. In contrast to **Figure 11a**, the potential well illustrated in **Figure 12a** is considerably narrower. The state in **Figure 12a** is now maintained for a predetermined time (for example in the region of a few milliseconds). The secondary ions are collected in the potential well (accumulation of the secondary ions) in this predetermined time (accumulation time). The first to sixteenth potentials are now switched such that the left-hand flank 1327 and the right-hand flank 1328 are moved along the second longitudinal axis 1307 (**Figures 12b to 12h**). The potential well in which the secondary ions are located is therefore also moved. The secondary ions are forced to move in the direction of the analysis unit 1400 by this movement of the left-hand flank 1327 and of the right-hand flank 1328. In this way, the secondary ions are transported in the ion transmission unit 1300. The movement of the left-hand flank 1327 and of the right-hand flank 1328 continues until the secondary ions are located slightly in front of the analysis unit 1400.

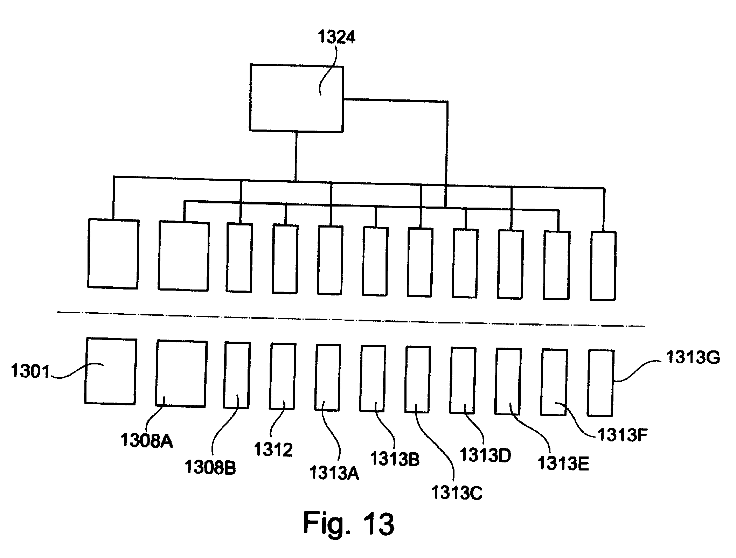

In a further embodiment, units of the ion transmission unit 1300 are connected in parallel, as is shown schematically in **Figure 13**. In this exemplary embodiment, the first quadrupole disk 1301, the second quadrupole device 1308B in the form of a disk, the third quadrupole device 1313A in the form of a disk, the fifth quadrupole device 1313C in the form of a disk, the seventh quadrupole device 1313E in the form of a disk and the ninth quadrupole device 1313G in the form of a disk are connected in parallel. Furthermore, the first quadrupole device 1308A in the form of a disk, the second quadrupole disk 1312, the fourth quadrupole device 1313B in the form of a disk, the sixth quadrupole device 1313D in the form of a disk and the eighth quadrupole device 1313F in the form of a disk are connected in parallel. It is explicitly noted that other parallel circuits, in particular of quadrupole devices that are quite a long distance away from one another, are provided in other embodiments.

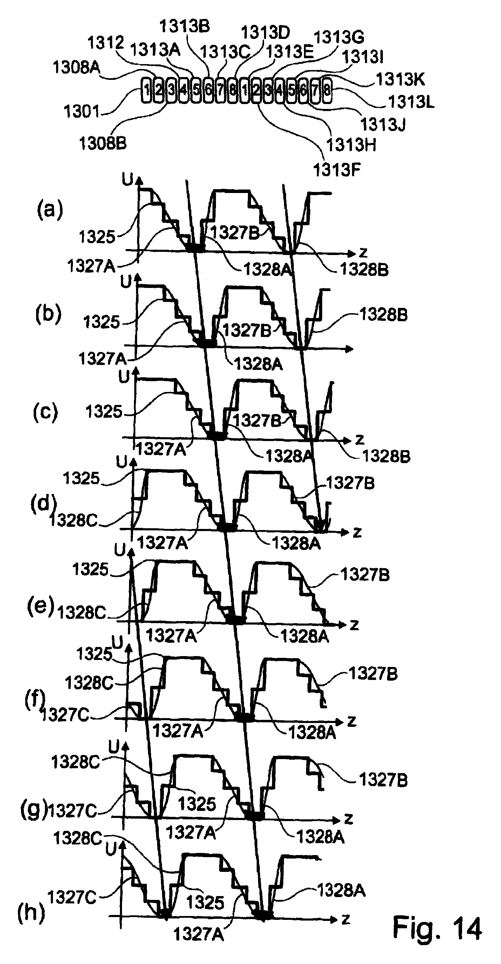

A further exemplary embodiment relating to parallel connection is shown in **Figure 14. Figure 14** is based on **Figure 11**, as a result of which reference is first of all made to all the above statements. **Figures 14a to 14h** show the time profile of the total potential, which is composed of the first to sixteenth potentials, in the ion transmission unit 1300, with **Figure 14a** showing the earliest instantaneous record of the total potential in time, and **Figure 14h** showing the latest instantaneous record of the total potential in time. The maximum total potential is once again in the region of a few volts here, for example 2 V to 3 V. In the exemplary embodiment illustrated in **Figure 14**, the following units are connected in parallel: the first quadrupole disk 1301 and the seventh quadrupole device 1313E in the form of a disk, the first quadrupole device 1308A in the form of a disk and the eighth quadrupole device 1313F in the form of a disk, the second quadrupole device 1308B in the form of a disk and the ninth quadrupole device 1313G in the form of a disk, the second quadrupole disk 1312 and the tenth quadrupole device 1313H in the form of a disk, the third quadrupole device 1313A in the form of a disk and the eleventh quadrupole device 1313I in the form of a disk, the fourth quadrupole device 1313B in the form of a disk and the twelfth quadrupole device 1313J in the form of a disk, the fifth quadrupole device 1313C in the form of a disk and the thirteenth quadrupole device 1313K in the form of a disk, as well as the sixth quadrupole device 1313D in the form of a disk and the fourteenth quadrupole device 1313L in the form of a disk. First of all, a first potential well and a second potential well are illustrated in **Figure 14a**. The first potential well has a first left-hand flank 1327A and a first right-hand flank 1328A. The second potential well has a second left-hand flank 1327B and a second right-hand flank 1328B. The first left-hand flank 1327A of the first potential well is designed such that the secondary ions which still have only thermal energy can fall into the first potential well from the area of the first quadrupole disk 1301. The first right-hand flank 1328A, which is provided in the area of the fourth quadrupole device 1313B in the form of a disk and the fifth quadrupole device 1313C in the form of a disk, is designed to be sufficiently steep that the secondary ions can no longer leave the first potential well on the first right-hand flank 1328A. The first left-hand flank 1327A is also designed such that the secondary ions can no longer leave the first potential well, with the gas pressure in this area still being sufficiently high that the secondary ions can transmit energy to neutral gas particles by impacts. This ensures that the secondary ions can no longer leave the potential well. The state in **Figure 14a** is now maintained for a predetermined time (for example in the region of a few milliseconds). The secondary ions are collected in the first potential well (accumulation of the secondary ions) in this predetermined time (accumulation time). The first to sixteenth potentials are now switched such that, on the one hand, the first left-hand flank 1327A and the first right-hand flank 1328A, and on the other hand the second left-hand flank 1327B and the second right-hand flank 1328B, are moved along the second longitudinal axis 1307 (**Figures 14b to 14h**). Both the first potential well and the second potential well are therefore moved. The secondary ions are forced to move in the direction of the analysis unit 1400 by this movement of the first left-hand flank 1327A and of the first right-hand flank 1328A. In this way, the secondary ions are transported in the ion transmission unit 1300. The first left-hand flank 1327A and the first right-hand flank 1328A are moved until the secondary ions are located slightly in front of the analysis unit 1400. In the exemplary embodiment illustrated in **Figure 14**, new potential wells are repeatedly generated. As can be seen from **Figures 14d to 14h**, a third potential well is created with a third left-hand flank 1327C and a third right-hand flank 1328C. Secondary ions can now once again fall into this third potential well. The third potential well is then moved along the second longitudinal axis 1307, to be precise in the same way as that described above. If **Figure 14** is considered, then this gives the impression that a wave of potential wells is moved in the direction of the analysis unit 1400 in the ion transmission unit 1300. In this case, the left-hand flank and the right-hand flank of each potential well are formed slowly.

The embodiments described above ensure that no significant kinetic energy is supplied to the secondary ions in this way of transport. They remain focused both axially and radially with respect to the second longitudinal axis 1307.

Because of unavoidable field errors in one of the quadrupole alternating fields which are generated in the ion transmission unit 1300, secondary ions can absorb kinetic energy in the area between two of the abovementioned quadrupole devices 1308A, 1308B and 1313A to 1313L, for example in the area between the first quadrupole device 1308A in the form of a disk and the second quadrupole device 1308B in the form of a disk. It is therefore worth considering designing this area, or even the entire ion transmission unit 1300, to be relatively short. However, this would decrease the effect of the further function of the ion transmission unit 1300, specifically the function as a pressure stage. It has now been shown that the solution described above (distributed pressure stage with transport of the secondary ions) represents a good compromise.

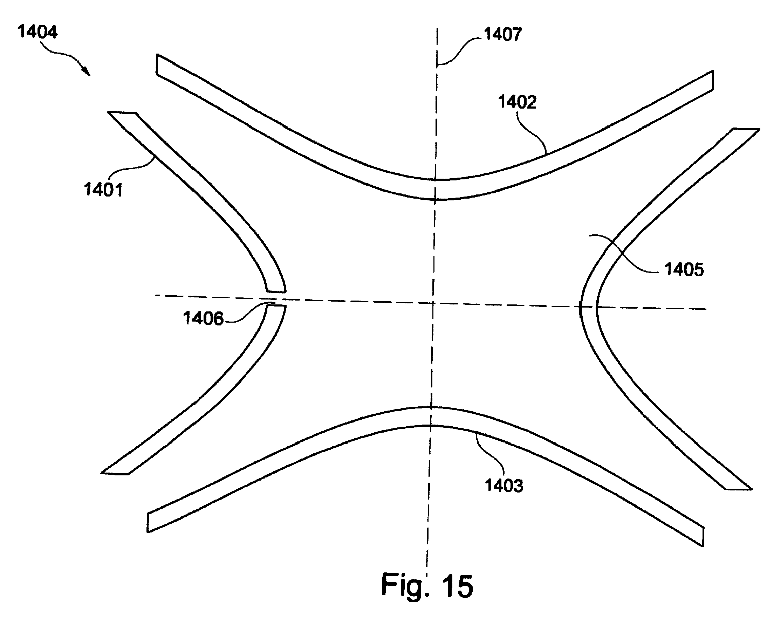

The analysis unit 1400 (that is to say a detection unit) in the exemplary embodiment described here is in the form of a mass spectrometer, for example a time-of-flight mass spectrometer or ion-trap mass spectrometer. In particular, the analysis unit 1400 is designed such that it can be replaced, as already mentioned above. Figure 15 shows a schematic section illustration of a storage cell 1404 of an ion-trap mass spectrometer. The storage cell 1404 is in the form of a Paul trap, and has an annular electrode 1401, a first end cap electrode 1402 and a second end cap electrode 1403. The annular electrode 1401 is arranged to be rotationally symmetrical around a first axis 1407. The first end cap electrode 1402 and the second end cap electrode 1403 are likewise arranged to be rotationally symmetrical around the first axis 1407. The annular electrode 1401 has an opening 1406 through which secondary ions can be injected into a second internal area 1405 in the storage cell 1404 from the ion transmission unit 1300. A storage field in the storage cell 1404 is switched off during the injection of the secondary ions. An electrical pulse is used to inject the secondary ions into the storage cell 1404, with these secondary ions having been transported by the ion transmission unit 1300 to the analysis unit 1400 and being located in one of the abovementioned potential wells immediately in front of the storage cell 1404. Because of the pulse, the secondary ions are supplied with kinetic energy, although this is the same for each secondary ion. This results in mass dispersion. Lightweight secondary ions travel back a greater distance than heavyweight secondary ions in the same time. This may lead to the problem that lightweight secondary ions arrive at the annular electrode 1401 before the heavyweight secondary ions have passed through the opening 1406 into the second internal area 1405 of the storage cell 1404. In order to reduce the effect of mass dispersion, a potential is applied via the first end cap electrode 1402 and the second end cap electrode 1403 such that a static quadrupole field is generated in the internal area 1405 of the storage cell 1404, such that secondary ions are braked in the center of the storage cell 1404. The abovementioned potential is therefore also referred to as a braking potential. The lightweight secondary ions are affected by the braking potential at a time before the heavyweight secondary ions, as a result of which the heavyweight secondary ions are able to "pull in" the lightweight secondary ions. As soon as the heavyweight secondary ions are in the second internal area 1405 of the storage cell 1404, the storage field is activated.

Because of the pulse, it is possible for the radial component of the kinetic energy of the secondary ions to be greater on entering the storage cell 1404 than the radial component of the kinetic energy of the secondary ions in the ion transmission unit 1300. The radial component of the kinetic energy of the secondary ions on entering the storage cell 1404 should be as low as possible (for example in the region of a few hundred meV), since this is otherwise converted to potential energy of the secondary ions in the storage cell 1404. In this case, the amplitude of the macro-oscillations of the secondary ions in the second internal area 1405 of the storage cell 1404 would be high, and the secondary ions would be lost for analysis.

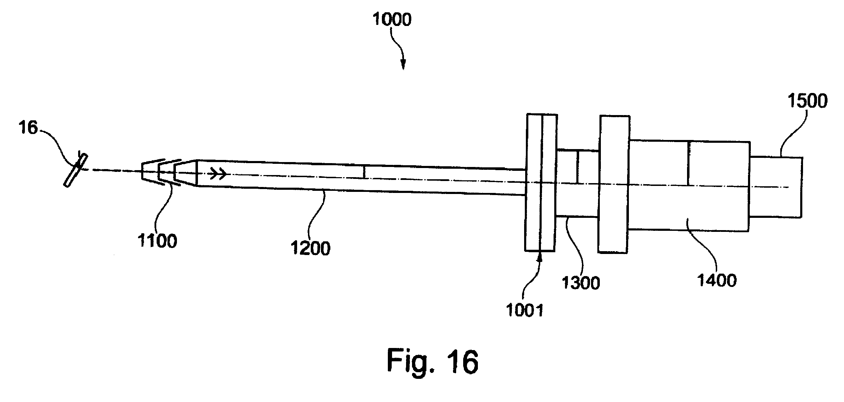

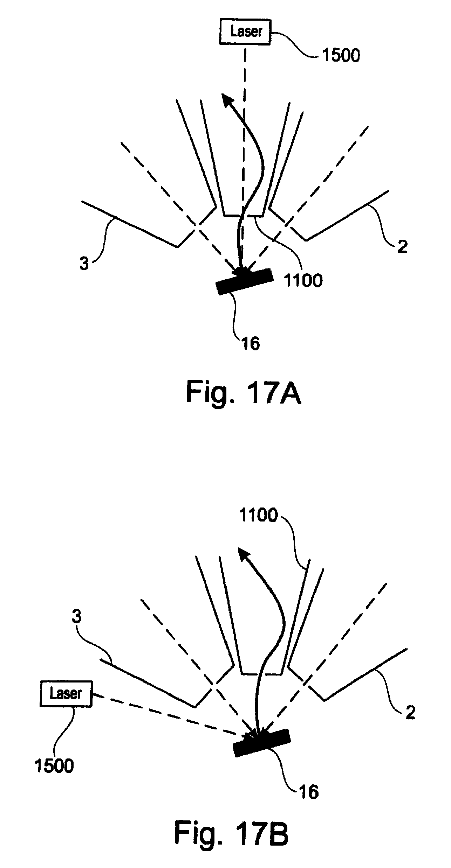

**Figure 16** shows a further embodiment of the particle analysis apparatus 1000, in the form of a schematic side view, provided in the particle beam device 1 shown in **Figure 2. Figure 16** is based on **Figure 3**. The same components are provided with the same reference symbols. The particle analysis apparatus 1000 has the extraction unit 1100, the apparatus for energy transmission 1200, the ion transmission unit 1300 and the analysis unit 1400. The ion transmission unit 1300 and the analysis unit 1400 are arranged detachably on the sample chamber 49 via the connecting element 1001. A laser unit 1500 is additionally arranged on the analysis unit 1400 and makes it possible to pass a laser beam through the analysis unit 1400, through the ion transmission unit 1300, through the apparatus for energy transmission 1200 and through the extraction unit 1100 to the sample 16. **Figure 17A** shows a schematic arrangement of the particle analysis apparatus 1000 in the particle beam device 1, in which case, in order to improve the clarity, **Figure 17A** shows only the sample 16, the first particle beam column 2, the second particle beam column 3, the extraction unit 1100 and the laser unit 1500. Irradiation of the sample 16 by means of the laser beam makes it possible to generate further secondary ions on the sample 16, in addition to or as an alternative to generating secondary ions by means of the ion beam. The further secondary ions are then analyzed by means of the particle analysis apparatus 1000. This embodiment has the advantage that a relatively large area is illuminated by means of the laser beam, such that more secondary ions are produced in a predetermined time period by the sample 16 than is possible only by means of the ion beam. This leads to shorter accumulation times, that is to say the secondary ions are collected in the abovementioned potential well, thus allowing faster evaluation by mass analysis of the secondary ions. This embodiment is also advantageous for examination of dielectric samples. These are charged when bombarded with ions, as a result of which imaging by means of the second particle beam column 3 by means of electrons is impossible. For this reason, only the laser beam of the laser unit 1500 can be used to generate secondary ions, instead of the ion beam.

Furthermore, in the embodiment illustrated in **Figure 17A**, it is advantageous for the laser unit 1500 to be aligned with the particle analysis apparatus 1000 such that the laser beam is aligned parallel to the axis of the particle analysis apparatus 1000. This avoids an additional connection to the sample chamber for the laser unit 1500.

In yet another embodiment it is possible to use the laser beam of the laser unit 1500 for optical imaging at light frequencies. This results in a further examination method for the surface of the sample 16, in addition to imaging by means of electrons or ions.

In a further embodiment it is provided for the laser beam of the laser unit 1500 to be used for sample positioning and for finding a coincidence point of the ion beam and of the electron beam.

In yet another embodiment, the energy of the laser beam can be used in order to ionize neutral particles released from the sample 16. This increases the analysis efficiency by means of the particle analysis apparatus 1000.

Furthermore, certain areas of the sample 16 can be heated by means of the laser beam of the laser unit 1500. This makes it possible to carry out examinations on the sample 16 as a function of their temperature. Furthermore, this makes it possible to reduce the work function of the secondary ions, in order to achieve a higher "yield" of secondary ions.

In a further embodiment, spectroscopy can be carried out on secondary ions by means of laser light.

Furthermore, in the described exemplary embodiment, the sample 16 is irradiated alternately or successively by means of the ion beam and the laser beam from the laser unit 1500. For example, material can be removed coarsely from the sample 16 by means of the laser beam. This also results in secondary ions, which are analyzed. The coarse removal is continued until a specific element has been determined by the particle analysis apparatus 1000. Finer removal is then carried out, using the focused ion beam.

**Figure 17B** is based on the exemplary embodiment shown in **Figure 17A**. The same components are provided with the same reference symbols. Reference is therefore first of all made to all the comments made above, which also apply to the exemplary embodiment shown in **Figure 17B**. In contrast to the exemplary embodiment shown in **Figure 17A**, in the case of the exemplary embodiment shown in **Figure 17B**, the laser unit 1500 is not arranged on the particle analysis apparatus 1000, but at the side, on the sample chamber 49.

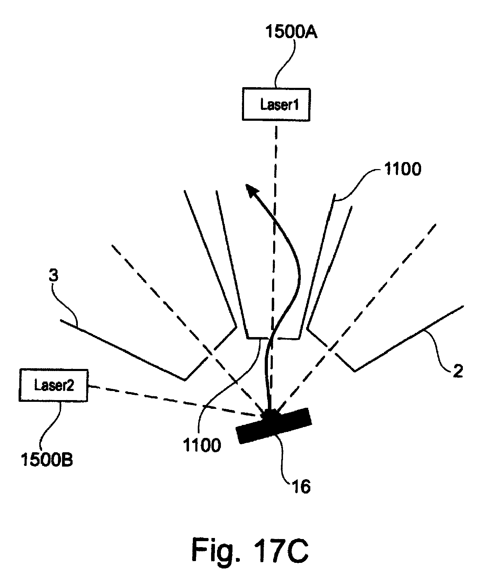

**Figure 17C** is likewise based on the exemplary embodiment shown in **Figure 17A**. The same components are provided with the same reference symbols. Reference is therefore first of all made to all the comments made above, which also apply to the exemplary embodiment shown in **Figure 17C**. In contrast to the exemplary embodiment shown in **Figure 17A**, two laser units are provided in the exemplary embodiment shown in **Figure 17C**. A first laser unit 1500A is arranged on the particle analysis apparatus 1000 (for example on the analysis unit 1400). Furthermore, a second laser unit 1500B is arranged on the sample chamber 49. Both the first laser unit 1500A and the second laser unit 1500B have at least one of the functions which have been explained further above.

It is explicitly also noted that the invention described above, in particular all of the embodiments of the invention mentioned above, is suitable both for positively charged ions and for negatively charged ions. The potentials described above will be chosen appropriately by a person skilled in the art, by inversion and adaptation of the potentials described above.

**List of reference symbols**

| 1 | Particle beam device |
| 2 | First particle beam column (ion beam column) |
| 3 | Second particle beam column (electron beam column) |
| 4 | First optical axis |
| 5 | Second optical axis |
| 6 | Second beam generator |
| 7 | First electrode |
| 8 | Second electrode |
| 9 | Third electrode |
| 10 | Beam guide tube |
| 11 | Collimator arrangement |
| 12 | First annular coil |
| 13 | Yoke |
| 14 | Pinhole diaphragm |
| 15 | Detector |
| 16 | Sample |
| 17 | Central opening |
| 18 | Second objective lens |
| 19 | Magnetic lens |
| 20 | Electrostatic lens |
| 21 | Second annular coil |

| 22 | Inner pole shoe |
| 23 | Outer pole shoe |
| 24 | End of beam guide tube |
| 25 | Terminating electrode |
| 26 | Raster means |
| 27 | First beam generator |
| 28 | Extraction electrode |
| 29 | Collimator |
| 30 | Variable aperture |
| 31 | First objective lens |
| 32 | Raster electrodes |
| 41 | Control electrode |
| 42 | Recess |
| 43 | Outer surface |
| 46 | Third voltage supply unit |
| 47 | Fourth voltage supply unit |
| 49 | Sample chamber |
| 1000 | Particle analysis apparatus |
| 1001 | Connecting element (for the sample chamber) |
| 1100 | Extraction unit |
| 1135 | First cavity |
| 1136 | First extractor electrode |
| 1137 | Second extractor electrode |
| 1138 | Second cavity |
| 1139 | First inlet opening |
| 1140 | Second inlet opening |
| 1141 | First end section |
| 1142 | Second end section |
| 1144 | First voltage supply unit |

| | | | | |
|---|---|---|---|---|
| 1148 | Second voltage supply unit | | 1207 | First container end |
| 1200 | Apparatus for energy transmission | | 1208 | Area of the twenty second segment 1202V |
| 1201 | Tubular container | | 1209 | Second electronic circuit |
| 1202A | First segment | | 1210 | Potential well |
| 1202B | Second segment | | 1211 | Segment potential |
| 1202C | Third segment | | 1212 | Guiding potential |
| 1202D | Fourth segment | | 1300 | Ion transmission unit |
| 1202E | Fifth segment | | 1301 | First quadrupole disk |
| 1202F | Sixth segment | | 1302 | First through-opening |
| 1202G | Seventh segment | | 1303A | First hyperbolic printed circuit board electrode |
| 1202H | Eighth segment | | 1303B | Second hyperbolic printed circuit board electrode |
| 1202I | Ninth segment | | 1303C | Third hyperbolic printed circuit board electrode |
| 1202J | Tenth segment | | 1303D | Fourth hyperbolic printed circuit board electrode |
| 1202K | Eleventh segment | | 1303E | Fifth hyperbolic printed circuit board electrode |
| 1202L | Twelfth segment | | 1303F | Sixth hyperbolic printed circuit board electrode |
| 1202M | Thirteenth segment | | 1303G | Seventh hyperbolic printed circuit board electrode |
| 1202N | Fourteenth segment | | 1303H | Eighth hyperbolic printed circuit board electrode |
| 12020 | Fifteenth segment | | 1303I | Ninth hyperbolic printed circuit board electrode |
| 1202P | Sixteenth segment | | 1303J | Tenth hyperbolic printed circuit board electrode |
| 1202Q | Seventeenth segment | | 1303K | Eleventh hyperbolic printed circuit board electrode |
| 1202R | Eighteenth segment | | 1303L | Twelfth hyperbolic printed circuit board electrode |
| 1202S | Nineteenth segment | | | |
| 1202T | Twentieth segment | | 1304 | Insulating layer |
| 1202U | Twenty first segment | | 1305 | First outer surface |
| 1202V | Twenty second segment | | 1306 | Second outer surface |
| 1203 | Printed circuit board electrodes | | 1307 | Second longitudinal axis |
| 1204 | Insulation element | | | |
| 1205 | First longitudinal axis | | | |
| 1206 | First internal area | | | |

| 1308A | First quadrupole device in the form of a disk | | 1325 | Stepped potential profile |
|---|---|---|---|---|
| 1308B | Second quadrupole device in the form of a disk | | 1326 | Ideal potential profile |
| 1309 | Gas inlet | | 1327 | Left-hand flank |
| 1310 | First intermediate area | | 1327A | First left-hand flank |
| 1311 | Second intermediate area | | 1327B | Second left-hand flank |
| 1312 | Second quadrupole disk | | 1327C | Third left-hand flank |
| 1313A | Third quadrupole device in the form of a disk | | 1328 | Right-hand flank |
| 1313B | Fourth quadrupole device in the form of a disk | | 1328A | First right-hand flank |
| 1313C | Fifth quadrupole device in the form of a disk | | 1328B | Second right-hand flank |
| 1313D | Sixth quadrupole device in the form of a disk | | 1328C | Third right-hand flank |
| 1313E | Seventh quadrupole device in the form of a disk | | 1329 | Channel |
| 1313F | Eighth quadrupole device in the form of a disk | | 1400 | Analysis unit |
| 1313G | Ninth quadrupole device in the form of a disk | | 1401 | Annular electrode |
| 1313H | Tenth quadrupole device in the form of a disk | | 1402 | First end cap electrode |
| 1313I | Eleventh quadrupole device in the form of a disk | | 1403 | Second end cap electrode |
| 1313J | Twelfth quadrupole device in the form of a disk | | 1404 | Storage cell |
| 1313K | Thirteenth quadrupole device in the form of a disk | | 1405 | Second internal area (storage cell) |
| 1313L | Fourteenth quadrupole device in the form of a disk | | 1406 | Opening |
| 1314 | Third intermediate area | | 1407 | First axis |
| 1315 | Fourth intermediate area | | 1500 | Laser unit |
| 1316 | Fifth intermediate area | | 1500A | First laser unit |
| 1317 | Sixth intermediate area | | 1500B | Second laser unit |
| 1318 | Seventh intermediate area | | KR | Core radius |
| 1319 | Eighth intermediate area | | A1 | Distance |
| 1320 | Ninth intermediate area | | | |
| 1321 | Second through-opening | | | |
| 1324 | Electronic circuit | | | |

**Claims**

1. Apparatus (1200) for transmission of energy of at least one ion to at least one gas particle in a gas and/or for transportation of an ion, having

   - a container (1201), in which a gas is arranged which has gas particles, wherein the container (1201) has a transport axis (1205) and a predeterminable shape,
- at least one first multipole unit (1202A - 1202V) and at least one second multipole unit (1202A - 1202V), which are arranged along the transport axis (1205) of the container (1201), wherein
- the first multipole unit (1202A - 1202V) is formed by a first printed circuit board which is matched to the predeterminable shape of the container (1201) and has first printed circuit board electrodes for generating a first multipole alternating field,
- the second multipole unit (1202A - 1202V) is formed by a second printed circuit board, which is matched to the predeterminable shape of the container (1201) and has second printed circuit board electrodes for generating a second multipole alternating field, and wherein
- the apparatus (1200) has at least one electronic circuit (1209), which provides a potential gradient along the transport axis (1205) of the container (1201), wherein a potential associated with that point is provided at each point on the transport axis (1205).

2. Apparatus (1200) according to Claim 1, wherein

- the first multipole unit (1202A - 1202V) is in the form of a first quadrupole unit for generating a first quadrupole alternating field, and wherein
- the second multipole unit (1202A - 1202V) is in the form of a second quadrupole unit for generating a second quadrupole alternating field.

3. Apparatus (1200) according to Claim 1 or 2, wherein

- the first printed circuit board and/or the second printed circuit board are/is formed from a flexible material.

4. Apparatus (1200) according to one of the preceding claims, wherein

- the first printed circuit board and the second printed circuit board are formed from a single printed circuit board,
- the single printed circuit board is segmented and has at least one first segment (1202A - 1202V) and at least one second segment (1202A - 1202V),
- the first segment (1202A - 1202V) forms the first multipole unit, and wherein
- the second segment (1202A - 1202V) forms the second multipole unit.

5. Apparatus (1200) according to one of the preceding claims, wherein

- the container (1201) has an internal area (1206) which is bounded by at least one internal area wall, and wherein
- the first multipole unit (1202A - 1202V) and the second multipole unit (1202A - 1202V) are arranged on the internal area wall.

6. Apparatus (1200) according to Claim 5, wherein

- the internal area is circular and has a radius (KR), and wherein
- the first multipole unit (1202A - 1202V) and/or the second multipole unit (1202A - 1202V) have/has a longitudinal extent in the direction of the longitudinal axis (1205) which corresponds to the radius (KR).

7. Apparatus (1200) according to one of the preceding claims, wherein

- the container (1201) has a first end (1207) and a second end,
- the first end (1207) has an inlet for ions and a first pressure stage (1100), and wherein
- the second end has an outlet for ions and a second pressure stage (1312).

8. Apparatus (1200) according to one of the preceding claims, wherein the apparatus (1200) has at least one of the following features:

- the container (1201) has a longitudinal extent in the direction of the transport axis (1205) in the range from 100 mm to 500 mm,
- the container (1201) has a longitudinal extent in the direction of the transport axis (1205) in the range from 200 mm to 400 mm, or
- the container (1201) has a longitudinal extent in the direction of the transport axis (1205) of 350 mm.

9. Apparatus (1200) according to one of claims 6 to 8, wherein the apparatus (1200) has at least one of the following features:

- the radius (KR) is in the range from 2 mm to 50 mm,
- the radius (KR) is in the range from 8 mm to 20 mm,
- the radius (KR) is in the range from 9 mm to 12 mm, or
- the radius (KR) is 10 mm, 9 mm or 8 mm.

10. Apparatus (1300) for transportation of at least one ion, having

- a transport axis (1307),
- at least one first multipole device (1301, 1308A, 1308B, 1312, 1313A - 1313L) and at least one second multipole device (1301, 1308A, 1308B, 1312, 1313A - 1313L), which are arranged along the transport axis (1307),

wherein

- the first multipole device (1301, 1308A, 1308B, 1312, 1313A - 1313L) is formed by a first printed circuit board having first printed circuit board electrodes for generating a first multipole alternating field, wherein the first printed circuit board has a first through-opening (1302),

- the second multipole device (1301, 1308A, 1308B, 1312, 1313A - 1313L) is formed by a second printed circuit board having second printed circuit board electrodes for generating a second multipole alternating field, wherein the second printed circuit board has a second through-opening (1302),

- the transport axis runs through the first through-opening and through the second through-opening, and wherein

- the apparatus (1300) has at least one electronic circuit (1324) for generating a first potential on the first multipole device (1301, 1308A, 1308B, 1312, 1313A - 1313L) and for generating a second potential on the second multipole device (1301, 1308A, 1308B, 1312, 1313A - 1313L), wherein the first potential and the second potential can be predetermined.

11. Apparatus (1300) according to claim 10, wherein the apparatus (1300) has at least one of the following features:

- the first multipole device (1301, 1308A, 1308B, 1312, 1313A- 1313L) is in the form of a first quadrupole device for generating a first quadrupole alternating field, or
- the second multipole device (1301, 1308A, 1308B, 1312, 1313A - 1313L) is in the form of a second quadrupole device for generating a second quadrupole alternating field.

12. Apparatus (1300) according to Claim 10 or 11, wherein the apparatus (1300) has at least one of the following features:

- the first multipole device (1301, 1308A, 1308B, 1312, 1313A - 1313L) has at least one first hyperbolic electrode, at least one second hyperbolic electrode, at least one third hyperbolic electrode and at least one fourth hyperbolic electrode, or
- the second multipole device (1301, 1308A, 1308B, 1312, 1313A - 1313L) has at least one fifth hyperbolic electrode, at least one sixth hyperbolic electrode, at least one seventh hyperbolic electrode and at least one eighth hyperbolic electrode.

13. Apparatus (1300) according to Claim 12, wherein the apparatus (1300) has at least one of the following features:

- the first multipole device (1301, 1308A, 1308B, 1312, 1313A - 1313L) has at least one ninth hyperbolic electrode, at least one tenth hyperbolic electrode, at least one eleventh hyperbolic electrode and at least one twelfth hyperbolic electrode, or
- the second multipole device (1301, 1308A, 1308B, 1312, 1313A - 1313L) has at least one thirteenth hyperbolic electrode, at least one fourteenth hyperbolic electrode, at least one fifteenth hyperbolic electrode and at least one sixteenth hyperbolic electrode.

14. Apparatus (1300) according to one of Claims 10 to 13, wherein the apparatus (1300) has at least one of the following features:

- the first multipole device (1301, 1308A, 1308B, 1312, 1313A - 1313L) is in the form of a disk, or
- the second multipole device (1301, 1308A, 1308B, 1312, 1313A - 1313L) is in the form of a disk.

15. Apparatus (1300) according to one of Claims 10 to 14, wherein

- the apparatus (1300) has at least one third multipole device (1301, 1308A, 1308B, 1312, 1313A - 1313L), in particular a third quadrupole device, and at least one fourth multipole device (1301, 1308A, 1308B, 1312, 1313A - 1313L), in particular a fourth quadrupole device,
- the first multipole device (1301, 1308A, 1308B, 1312, 1313A - 1313L) is connected in parallel with the third multipole device (1301, 1308A, 1308B, 1313A - 1313L), and wherein
- the second multipole device (1301, 1308A, 1308B, 1313A - 1313L) is connected in parallel with the fourth multipole device (1301, 1308A, 1308B, 1313A - 1313L).

16. Particle beam device (1), having

- a sample chamber (49),
- a sample (16) which is arranged in the sample chamber (49),
- at least one first particle beam column (2), wherein the first particle beam column (2) has a first beam generator (27) for generating a first particle beam, and has a first objective lens (31) for focusing the first particle beam onto the sample (16),

- at least one means (2, 1500, 1500A, 1500B) for generating secondary ions which are emitted from the sample (16),
- at least one collecting apparatus (1100) for collection of the secondary ions,
- at least one apparatus (1200) according to one of Claims 1 to 9, and/or
- at least one apparatus (1300) according to one of Claims 10 to 15, and having
- at least one analysis unit (1400) for analysis of the secondary ions.

17. Particle beam device (1) according to Claim 16, wherein the analysis unit (1400) is in the form of a mass spectrometer.

18. Particle beam device (1) according to Claim 16 or 17, wherein the analysis unit (1400) is arranged detachably on the apparatus (1300) according to one of Claims 10 to 15, by means of a connecting device (1001).

19. Particle beam device (1) according to one of Claims 16 to 18, wherein the particle beam device (1) has a laser unit (1500, 1500A, 1500B).

20. Particle beam device (1) according to Claim 19, wherein the means for generating secondary ions comprises the laser unit (1500, 1500A, 1500B).

21. Particle beam device (1) according to one of Claims 16 to 20, wherein the means (1500) for generating secondary ions is arranged

   - on the apparatus (1200) according to one of Claims 1 to 9,
   - on the apparatus (1300) according to one of Claims 10 to 15, or
   - on the analysis unit (1400).

22. Particle beam device (1) according to one of Claims 16 to 21, wherein

   - the particle beam device (1) has at least one second particle beam column (3), and wherein
   - the second particle beam column (3) has a second beam generator (6) for generating a second particle beam, and has a second objective lens (18) for focusing the second particle beam onto the sample (16).

23. Particle beam device (1) according to Claim 22, wherein the particle beam device (1) has one of the following features:

   - the second particle beam column (3) is in the form of an electron beam column, and the first particle beam column (2) is in the form of an ion beam column,
   or
   - the first particle beam column is in the form of an ion beam column, and the second particle beam column is in the form of an ion beam column.

Fig. 1

Fig. 2

Fig. 3

Fig. 4

Fig. 5A

Fig. 5B

Fig. 5C

Guiding potential

1212

1211

1210

1202  1207

A B C D E F G H I J K L M N O P Q R S T U V  1208

Locus (axial)

on the transport axis (longitudinal axis)

Fig. 6

**Fig. 7**

EP 2 355 128 A2

Fig. 8

Fig. 9

Fig. 10

EP 2 355 128 A2

Fig. 11

Fig. 12

**Fig. 13**

Fig. 14

Fig. 15

EP 2 355 128 A2

Fig. 16

Fig. 17A

Fig. 17B

Fig. 17C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102006059162 A1
- US 7473892 B2
- EP 1185857 B1
- US 5008537 A
- US 5376791 A
- WO 0104611 A
- US 20090294641 A
- US 5576540 A